# EUROPEAN PATENT APPLICATION

(11) **EP 3 444 259 A1**
(43) Date of publication of application: **20.02.2019**
(21) Application number: 18187942.0
(22) Date of filing: 08.08.2018
(51) Int. Cl.: C07F 15/00, H01L 51/50

(54) **ORGANOMETALLIC COMPOUND AND ORGANIC LIGHT-EMITTING DEVICE INCLUDING THE SAME**

(30) Priority: 09.08.2017 KR 20170101342
(71) Applicant: Samsung Electronics Co., Ltd., Gyeonggi-do 16677 (KR); Samsung SDI Co., Ltd., Gyeonggi-do (KR)
(72) Inventor: KIM, Jongsoo, 16678 Gyeonggi-do, (KR); SON, Wonjoon, 16678 Gyeonggi-do, (KR); JEONG, Daun, 16678 Gyeonggi-do, (KR); KIM, Sunghan, 16678 Gyeonggi-do, (KR); KIM, Joonghyuk, 16678 Gyeonggi-do, (KR); SON, Youngmok, 16678 Gyeonggi-do, (KR); SIM, Myungsun, 16678 Gyeonggi-do, (KR); LEE, Namheon, Gyeonggi-do, (KR); IHN, Sooghang, 16678 Gyeonggi-do, (KR)
(74) Representative: Elkington & Fife LLP

(57) **Abstract**

An organometallic compound represented by Formula 1, wherein the organometallic compound has a horizontal orientation ratio of a transition dipole moment in a range of about 85 percent to about 100 percent:

Formula 1 M(L₁)ₙ

wherein, in Formula 1, M is selected from a first-row transition metal of the Periodic Table of Elements, a second-row transition metal of the Periodic Table of Elements, and a third-row transition metal of the Periodic Table of Elements, n is 2 or 3, L₁ is a bidentate organic ligand bound to M, wherein L₁ does not comprise a fluoro group (-F), and wherein L₁ groups in the number of n are identical to each other.

## Description

### FIELD OF THE INVENTION

The present disclosure relates to an organometallic compound and an organic light-emitting device including the same.

### BACKGROUND OF THE INVENTION

Organic light-emitting devices (OLEDs) are self-emission devices that, as compared with conventional devices, have wide viewing angles, high contrast ratios, short response times, and excellent brightness, driving voltage, and response speed characteristics, and that produce full-color images.

Typical OLEDs include an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state to thereby generate light.

Various types of organic light emitting devices are known. However, there still remains a need in OLEDs having low driving voltage, high efficiency, high brightness, and long lifespan.

### SUMMARY OF THE INVENTION

Provided are a novel organometallic compound satisfying a specific parameter and an organic light-emitting device including the same.

Additional aspects will be set forth in part in the description which follows and, in part, will be apparent from the description, or may be learned by practice of the presented embodiments.

According to an aspect of an embodiment, an organometallic compound is represented by Formula 1 and has a horizontal orientation ratio of a transition dipole moment in a range of about 85 percent to about 100 percent:

Formula 1 M(L₁)ₙ

wherein, in Formula 1,
M is selected from a first-row transition metal of the Periodic Table of Elements, a second-row transition metal of the Periodic Table of Elements, and a third-row transition metal of the Periodic Table of Elements,
n is 2 or 3,
L₁ is a bidentate organic ligand bound to M,
wherein L₁ does not contain a fluoro group (-F), and
wherein L₁ groups in the number of n are identical to each other.

According to an aspect of another embodiment, an organic light-emitting device includes:
a first electrode;
a second electrode; and
an organic layer disposed between the first electrode and the second electrode,
wherein the organic layer includes an emission layer and at least one organometallic compound described above.

In the organic layer, the organometallic compound may serve as a dopant.

### BRIEF DESCRIPTION OF THE DRAWINGS

These and/or other aspects will become apparent and more readily appreciated from the following description of the embodiments, taken in conjunction with the accompanying drawings in which:
the FIGURE is a schematic cross-sectional view of an organic light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

In an embodiment, an organometallic compound may be represented by Formula 1, and may have a horizontal orientation ratio of a transition dipole moment in a range of about 85 percent (%) to about 100%:

Formula 1 M(L₁)ₙ

In Formula 1, M may be selected from a first-row transition metal of the Periodic Table of Elements, a second-row transition metal of the Periodic Table of Elements, and a third-row transition metal of the Periodic Table of Elements, n may be 2 or 3, L₁ may be a bidentate organic ligand bound to M, wherein L₁ may not be containing a fluoro group (-F), and wherein L₁ groups in the number of n may be identical to each other.

For example, a horizontal orientation ratio of a transition dipole moment of the organometallic compound may be, for example, in a range of about 85 percent (%) to about 100%, about 86% to about 100%, about 87% to about 100%, about 88% to about 100%, about 89% to about 100%, about 90% to about 100%, about 91% to about 100%, about 92% to about 100%, about 93% to about 100%, about 94% to about 100%, about 95% to about 100%, about 96% to about 100%, about 97% to about 100%, about 98% to about 100%, or about 99% to about 100%, or about 100%, but embodiments are not limited thereto.

In some embodiments, a horizontal orientation ratio of a transition dipole moment of the organometallic compound may be in a range of about 85% to about 95%, for example, about 87% to about 92%, but embodiments are not limited thereto.

The term "horizontal orientation ratio of a transition dipole moment", as used herein, refers to, in a film including the organometallic compound, a ratio of the organometallic compound having a transition dipole moment which is horizontal with respect to the plane of the film, relative to the total organometallic compound included in the film.

The horizontal orientation ratio of a transition dipole moment may be measured by using an angle-dependent photoluminescence (PL) measuring device. The description of the angle-dependent PL measuring device may be, for example, the same as that of the angle-dependent PL measuring device described in KR Patent Application No. 2013-0150834 incorporated herein by reference.

Since the organometallic compound has a high horizontal orientation ratio of a transition dipole moment as such, namely, a greatly oriented transition dipole moment (*i.e.,* a large optical orientation in a horizontal direction), when the film includes the organometallic compound, it may be possible for the organometallic compound to emit a large electric field in a vertical direction with respect to the film. Since light emitted by this mechanism may pass to the outside with high efficiency (*i.e.,* efficiency of light emitted from the organometallic compound passing to the outside in a device (*e.g.,* an organic light-emitting device) including a film (*e.g.,* an emission layer described herein) including the organometallic compound), an electronic device, *e.g.,* an organic light-emitting device, employing the organometallic compound, may have excellent luminous efficiency.

Furthermore, the organometallic compound may be represented by Formula 1, and in Formula 1, L₁ groups in the number of n may be identical to each other. That is, the organometallic compound may have a structure of a homoleptic complex as well as a large optical orientation in a horizontal direction as described above. Accordingly, unlike a heteroleptic complex produced by a complicated synthetic process with a low synthetic yield, which may cause an increase in the production cost of an electronic device (*e.g.,* an organic light-emitting device), the organometallic compound may be produced by a simple synthetic process with a high synthetic yield. Thus, the organometallic compound may contribute to a decrease in the cost of production of various electronic devices.

In addition, since L₁ in Formula 1 is a bidentate organic ligand which may be bound to M and not contain a fluoro group (-F), the organometallic compound may not include a fluoro group. A fluoro group may be separated from a ligand upon device storage and/or operation, which may cause the lifespan of a device to deteriorate; however, since the organometallic compound may not include a fluoro group as such, an electronic device, e.g., an organic light-emitting device, including the organometallic compound, may have a long lifespan.

M in Formula 1 may be selected from iridium (Ir), platinum (Pt), osmium (Os), titanium (Ti), zirconium (Zr), hafnium (Hf), europium (Eu), terbium (Tb), thulium (Tm), rhodium (Rh), ruthenium (Ru), rhenium (Re), beryllium (Be), magnesium (Mg), aluminum (Al), calcium (Ca), manganese (Mn), cobalt (Co), copper (Cu), zinc (Zn), gallium (Ga), germanium (Ge), palladium (Pd), silver (Ag), and gold (Au).

In an embodiment, in Formula 1, M may be iridium or osmium, and n may be 3; or M may be platinum or palladium, and n may be 2.

In one or more embodiments, the organometallic compound may be represented by Formula 2:

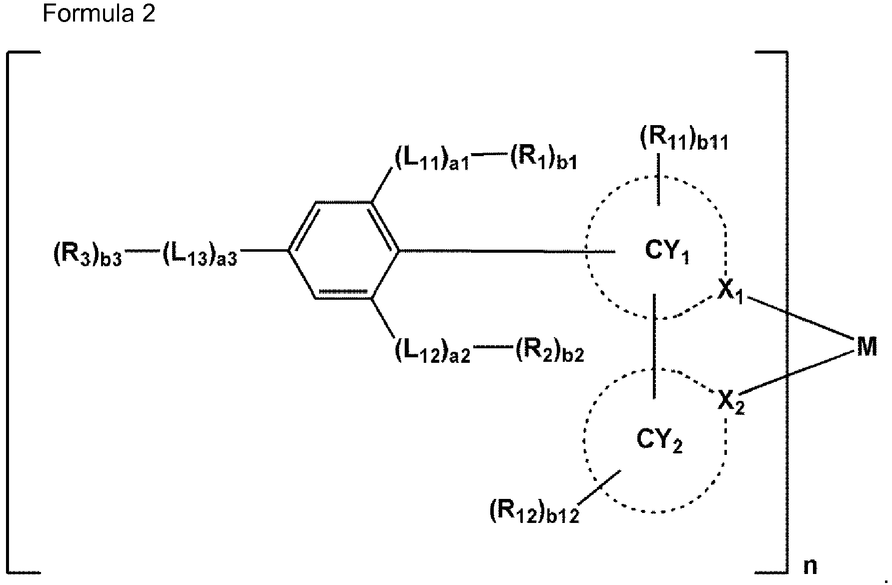

In Formula 2, M may be selected from a first-row transition metal of the Periodic Table of Elements, a second-row transition metal of the Periodic Table of Elements, and a third-row transition metal of the Periodic Table of Elements, and n may be 2 or 3. M and n may each be the same as those described herein.

In Formula 2, X₁ and X₂ may each independently be C or N.

In some embodiments, X₁ may be N, and X₂ may be C, but embodiments are not limited thereto.

In Formula 1, X₁ may be bound to M via a covalent bond, and X₂ may be bound to M via a coordinate bond; or X₁ may be bound to M via a coordinate bond, and X₂ may be bound to M via a covalent bond.

In some embodiments, X₁ may be bound to M via a coordinate bond, and X₂ may be bound to M via a covalent bond, but embodiments are not limited thereto.

In Formula 2, CY₁ and CY₂ may each independently be selected from a C₅-C30 carbocyclic group and a C₁-C₃₀ heterocyclic group.

In some embodiments, CY₁ and CY₂ may each independently be selected from i) a 5-membered ring, ii) a 6-membered ring, iii) a condensed ring in which two or more 6-membered rings may be condensed, and iv) a condensed ring in which at least one 6-membered ring and at least one 5-membered ring may be condensed,
the 5-membered ring may be selected from a cyclopentadiene group, a furan group, a thiophene group, a pyrrole group, a silole group, an oxazole group, an isoxazole group, an oxadiazole group, an isoxadiazole group, an oxatriazole group, a thiazole group, an isothiazole group, a thiadiazole group, an isothiadiazole group, a thiatriazole group, a pyrazole group, an imidazole group, a triazole group, a tetrazole group, an azasilole group, a diazasilole group, and a triazasilole group, and
the 6-membered ring may be selected from a cyclohexane group, a cyclohexene group, a benzene group, a pyridine group, a pyrimidine group, a pyrazine group, and a pyridazine group, but embodiments are not limited thereto.

In some embodiments, CY₁ and CY₂ may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, a cyclopentenopyridine group, a pyrrolopyridine group, a furopyridine group, and a thienopyridine group.

In Formula 1, L₁₁ to L₁₃ may each independently be selected from a substituted or unsubstituted C₅-C₃₀ carbocyclic group and a substituted or unsubstituted C₁-C₃₀ heterocyclic group.

In some embodiments, L₁₁ to L₁₃ may each independently be selected from:
a cyclopentadiene group, a cyclohexane group, a cyclohexene group, a benzene group, a naphthalene group, an anthracene group, a phenanthrene group, a triphenylene group, a pyrene group, a chrysene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group, each unsubstituted or substituted with at least one selected from deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, but embodiments are not limited thereto.

In Formula 2, a1, a2, and a3 respectively indicate the number of L₁₁ groups, L₁₂ groups, and L₁₃ groups, and may each independently be an integer from 0 to 5 (*e.g.,* an integer selected from 0, 1, and 2).

When a1 is 0, *-(L₁₁)ₐ₁₋*' may be a single bond; when a1 is two or greater, at least two L₁₁ groups may be identical to or different from each other; when a2 is 0, *-(L₁₂)ₐ₂-*' may be a single bond; when a2 is two or greater, at least two L₁₂ groups may be identical to or different from each other; when a3 is 0, *-(Li₃)ₐ₃-*' may be a single bond; and when a3 is two or greater, at least two L₁₃ groups may be identical to or different from each other.

In Formula 2, a sum of a1, a2, and a3 may be 1 or greater. That is, Formula 2 may essentially include at least one selected from L₁₁ to L₁₃, *i.e.,* cyclic groups as described herein.

In some embodiments, in Formula 2, a sum of a1, a2, and a3 may be 1, 2, 3, or 4.

In an embodiment, in Formula 2,
i) a1 and a2 may each independently be 1 or 2, and a3 may be 0;
ii) a1 and a2 may each be 0, and a3 may be 1, 2, or 3; or
iii) a1 to a2 may each be 1, but embodiments are not limited thereto.

In Formula 2, R₁ to R₃ may each independently be selected from hydrogen, deuterium, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and-P(=O)(Q₈)(Q₉).

In Formula 2, b1, b2, and b3 respectively indicate the number of R₁ groups, R₂ groups, and R₃ groups, and may each independently be an integer from 0 to 5 (e.g., an integer selected from 0, 1, 2, and 3). When b1 is two or greater, at least two R₁ groups may be identical to or different from each other; when b2 is two or greater, at least two R₂ groups may be identical to or different from each other; and when b3 is two or greater, at least two R₃ groups may be identical to or different from each other.

In Formula 2, R₁₁ and R₁₂ may each independently be selected from:
hydrogen, deuterium, a cyano group, a C₁-C₆₀ alkyl group, a C₂-C₆₀ alkenyl group, a C₂-C₆₀ alkynyl group, and a C₁-C₆₀ alkoxy group; and
a C₁-C₆₀ alkyl group, a C₂-C₆₀ alkenyl group, a C₂-C₆₀ alkynyl group, and a C₁-C₆₀ alkoxy group, each substituted with at least one selected from deuterium, a cyano group, a C₁-C₆₀ alkyl group, a C₂-C₆₀ alkenyl group, a C₂-C₆₀ alkynyl group, and a C₁-C₆₀ alkoxy group.

That is, in Formula 2, R₁₁ and R₁₂ may not include a cyclic group.

In Formula 2, b11 and b12 respectively indicate the number of R₁₁ groups and R₁₂ groups, and may each independently be an integer from 0 to 10 *(e.g.,* an integer selected from 0, 1, 2, and 3). When b11 is two or greater, at least two R₁₁ groups may be identical to or different from each other, and when b12 is two or greater, at least two R₁₂ groups may be identical to or different from each other.

In some embodiments, in Formula 2, R₁ to R₃, R₁₁, and R₁₂ may each independently be selected from:
hydrogen, deuterium, a cyano group, a C₁-C₁₀ alkyl group, and a C₁-C₁₀ alkoxy group; and
a C₁-C₁₀ alkyl group and a C₁-C₁₀ alkoxy group, each substituted with at least one selected from deuterium, a cyano group, a C₁-C₁₀ alkyl group, and a C₁-C₁₀ alkoxy group.

In some embodiments, in Formula 2, R₁ to R₃, R₁₁, and R₁₂ may each independently be selected from:
hydrogen, deuterium, and a cyano group; and
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a methoxy group, an ethoxy group, a propoxy group, a butoxy group, and a pentoxy group, each unsubstituted or substituted with at least one selected from deuterium and a cyano group.

In some embodiments, in Formula 2, R₁ to R₃, R₁₁, and R₁₂ may each independently be selected from hydrogen, deuterium, a cyano group, -CH₃, -CD₃,-CD₂H, -CDH₂, -CH₂CD₂H, -CH₂CDH₂, -CHDCH₃, -CHDCD₂H, -CHDCDH₂, -CHDCD₃, -CD₂CD₃, -CD₂CH₃, -CD₂CD₂H, -CD₂CDH₂, groups represented by Formulae 9-1 to 9-24, a methoxy group, an ethoxy group, a propoxy group, a butoxy group, and a pentoxy group, but embodiments are not limited thereto: 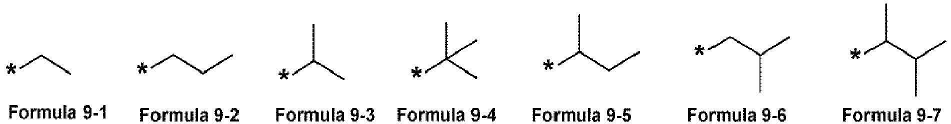 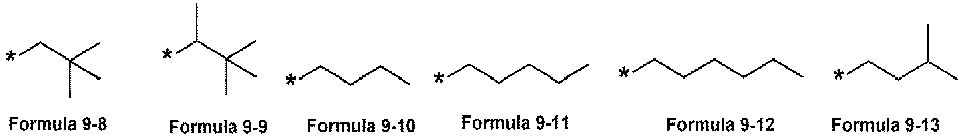 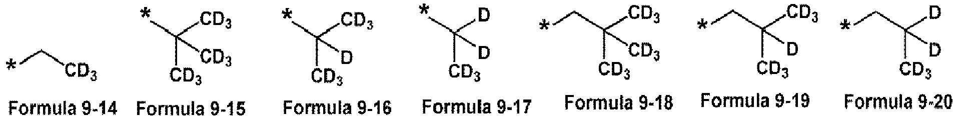 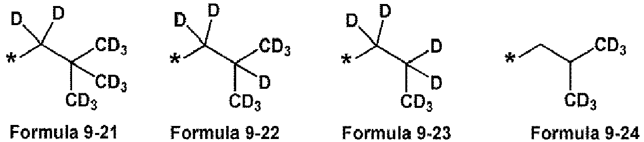 wherein, in Formulae 9-1 to 9-24, * indicates a binding site to an adjacent atom.

In some embodiments, in Formula 1, *-(L₁₁)ₐ₁-(R₁)_{b1}, *-(L₁₂)ₐ₂-(R₂)_{b2}, and *-(L₁₃)ₐ₃-(R₃)_{b3} may each independently be selected from:
hydrogen, deuterium, a cyano group, a C₁-C₁₀ alkyl group, and a C₁-C₁₀ alkoxy group;
a C₁-C₁₀ alkyl group and a C₁-C₁₀ alkoxy group, each substituted with at least one selected from deuterium, a cyano group, a C₁-C₁₀ alkyl group, and a C₁-C₁₀ alkoxy group; and
groups represented by Formulae 10-1 to 10-154, and
at least one selected from *-(L₁₁)ₐ₁-(R₁)_{b1}, *-(L₁₂)ₐ₂-(R₂)_{b2}, and *-(L₁₃)ₐ₃-(R₃)_{b3} may independently be selected from groups represented by Formulae 10-1 to 10-4, 10-9, 10-10 and 10-13 to 10-154: 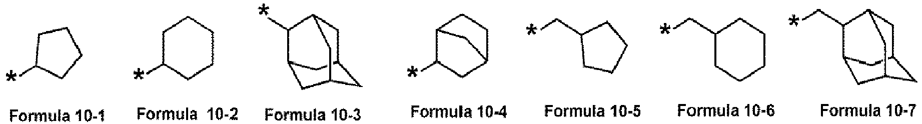 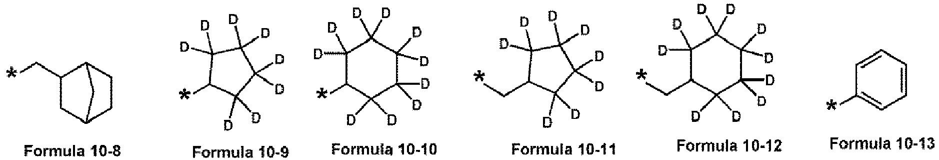 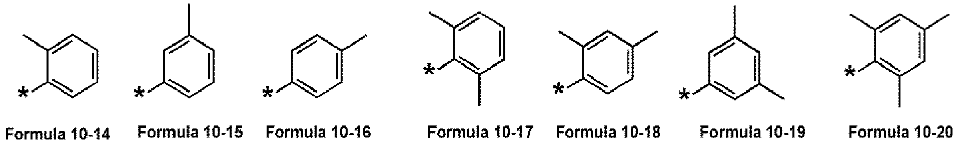 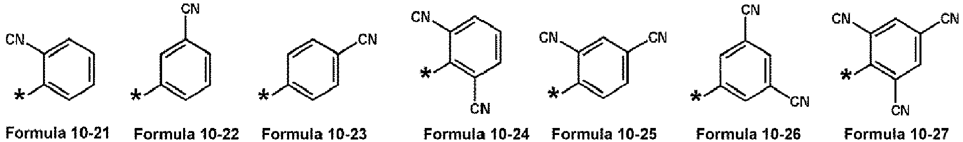 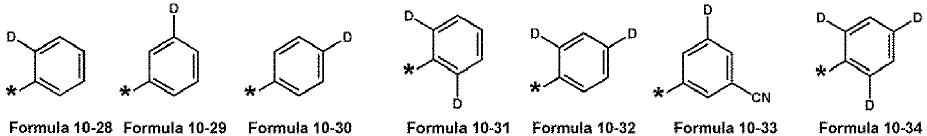 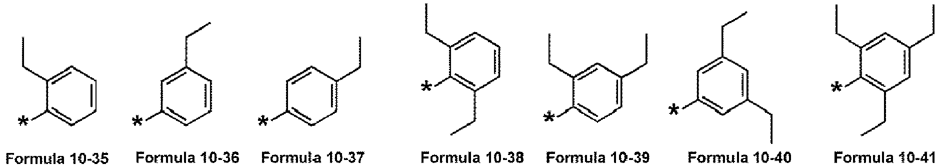 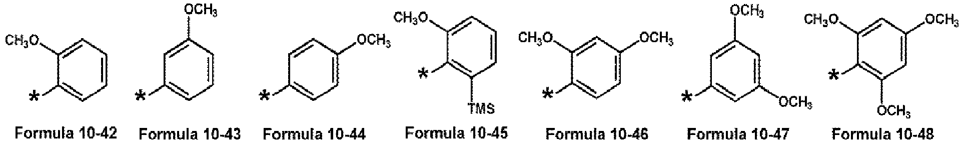 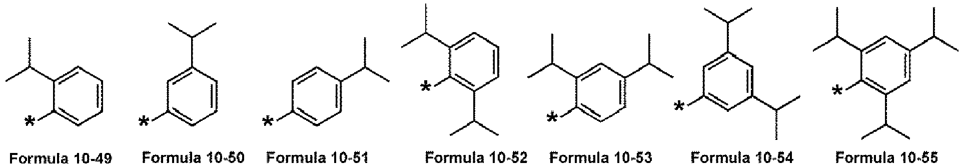 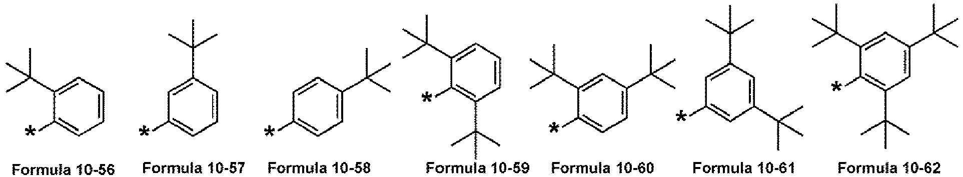 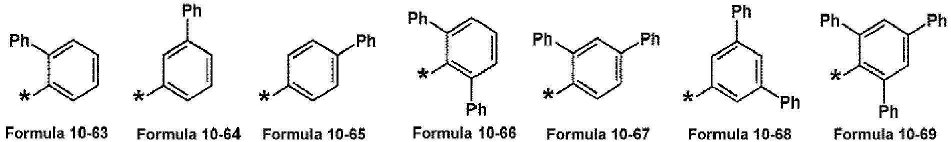 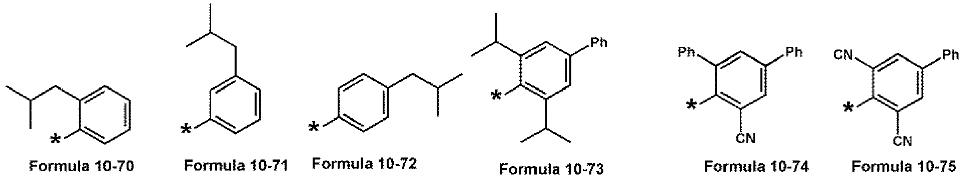 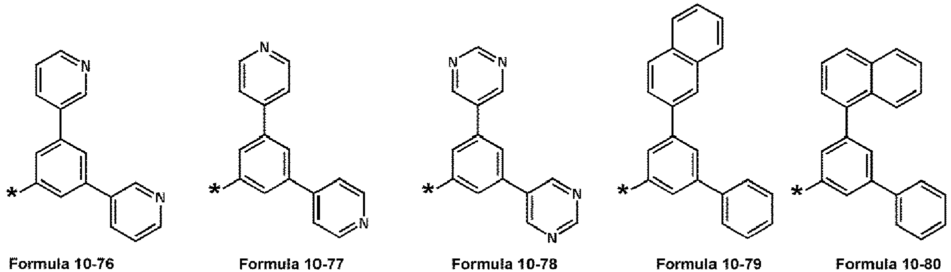 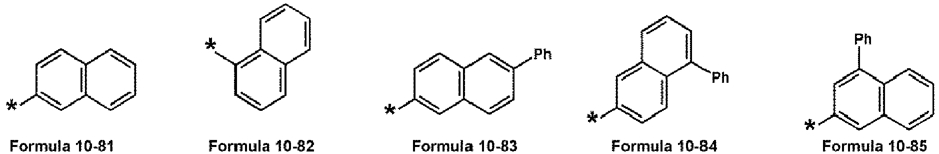 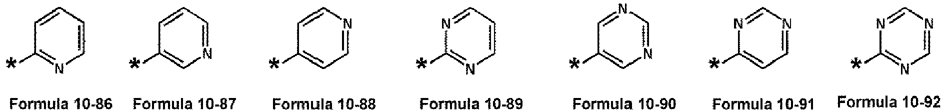 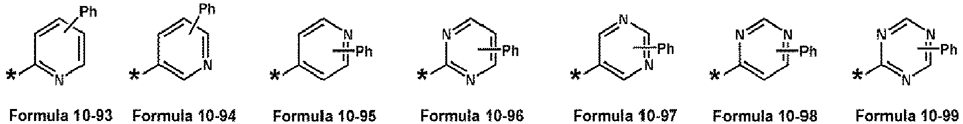 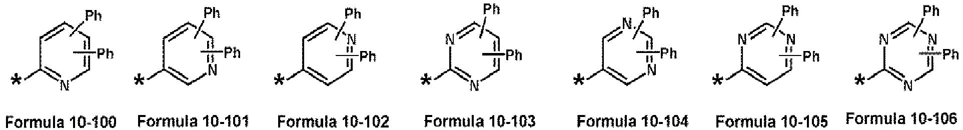 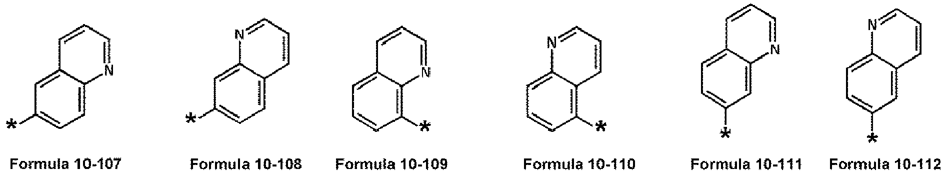 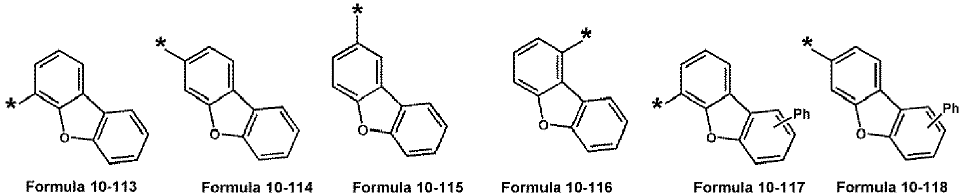 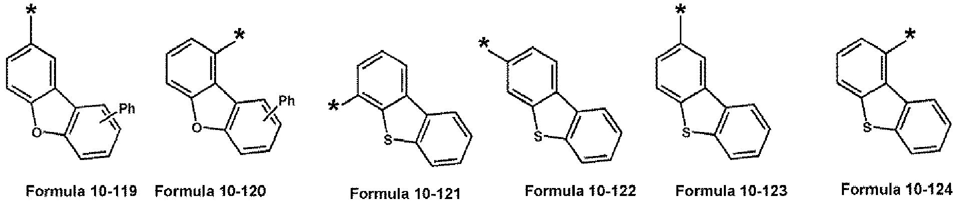 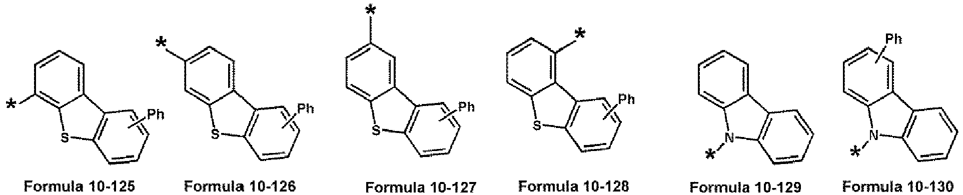 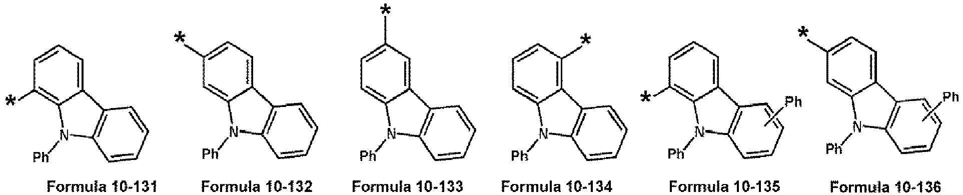 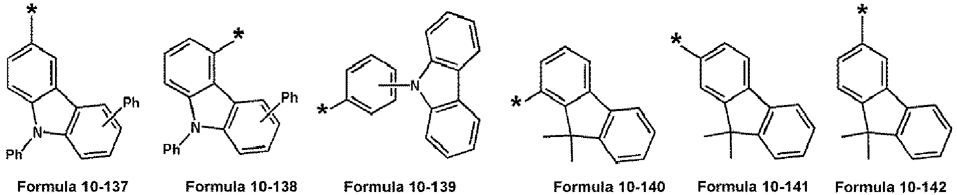 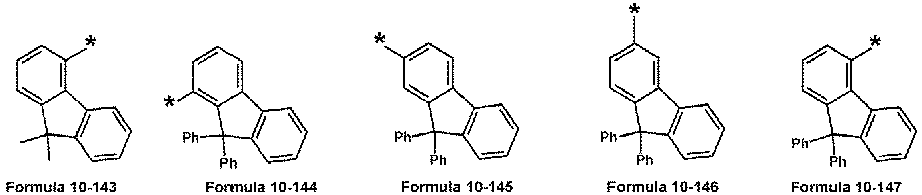 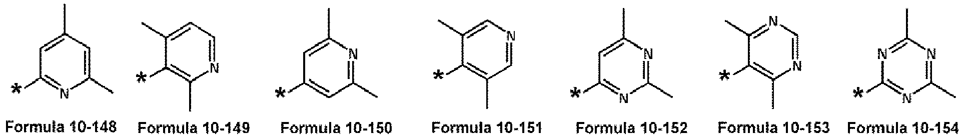
wherein, in Formulae 10-1 to 10-154, Ph represents a phenyl group, and * indicates a binding site to an adjacent atom.

The organometallic compound represented by Formula 2 may not include a fluoro group (-F). Accordingly, an electronic device, e.g., an organic light-emitting device, including the organometallic compound represented by Formula 2 may have long lifespan.

The organometallic compound represented by Formula 1 or Formula 2 may be represented by one of Formulae 2A to 2C: 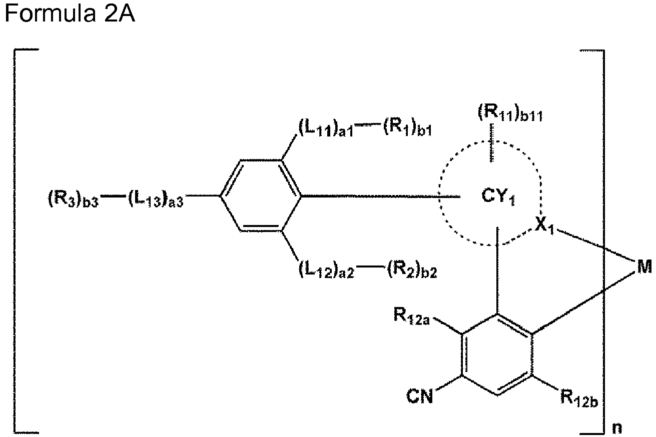 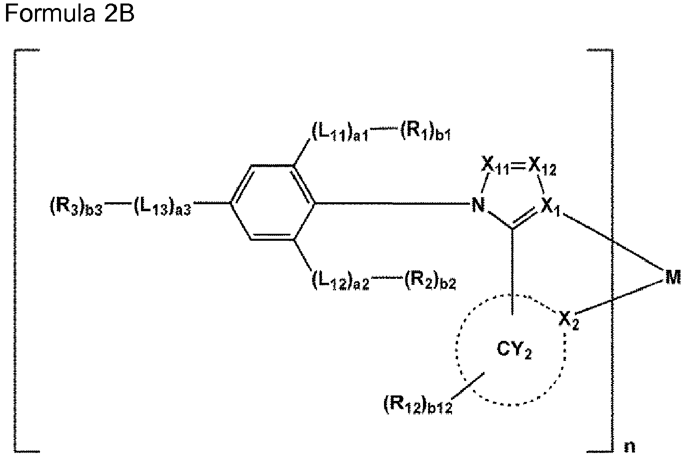 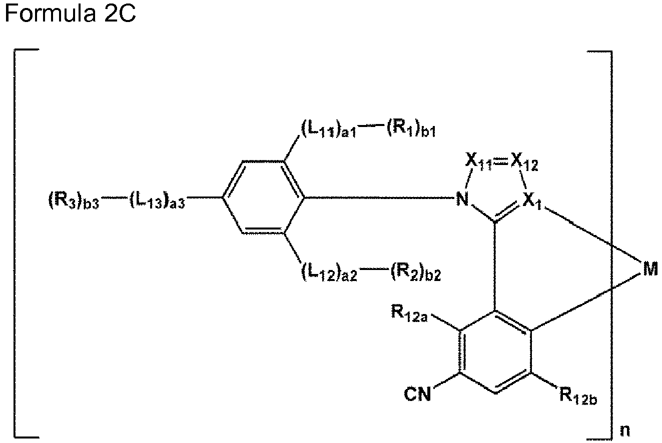 wherein, in Formulae 2A to 2C,
M, n, X₁, X₂, CY₁, CY₂, L₁₁ to L₁₃, a1 to a3, R₁ to R₃, b1 to b3, R₁₁, R₁₂, b11, and b12 may be the same as those described herein,
X₁₁ may be N or C(R₁₁ₐ), X₁₂ may be N or C(R_{11b}),
R₁₁ₐ and R_{11b} may each be the same as R₁₁ described herein, and R₁₂ₐ and R_{11b} may each be the same as R₁₂ described herein.

In some embodiments, the organometallic compound may be selected from Compounds 1 to 9, but embodiments are not limited thereto:

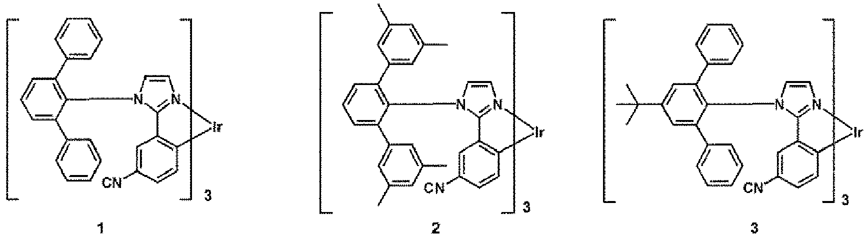

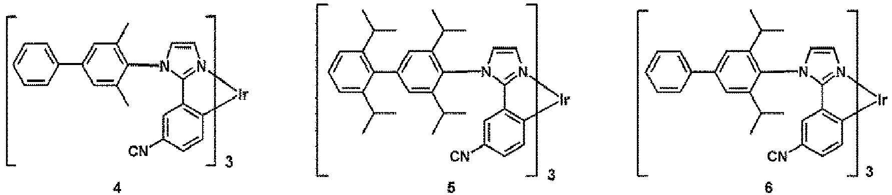

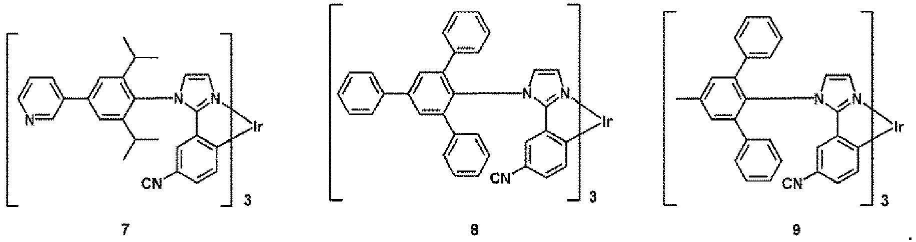

The organometallic compound may emit light of a wide range of wavelengths.

In some embodiments, the organometallic compound may emit red light, green light, or blue light.

In an embodiment, a peak emission wavelength of the organometallic compound may be in a range of about 440 nanometers (nm) to about 470 nm (for example, about 440 nm to about 467 nm). When the peak emission wavelength of the organometallic compound is in a range of about 440 nm to about 470 nm, the organic light-emitting device may provide a deep blue emission color.

A method of synthesizing the organometallic compound represented by Formula 1 may be apparent to one of ordinary skill in the art by referring to Synthesis Examples provided herein.

The organometallic compound represented by Formula 1 may be suitable for use in an organic layer of an electronic device, e.g., an organic light-emitting device, for example, as a dopant in an emission layer of the organic layer. Thus, according to another aspect of the present description, there is provided an organic light-emitting device that may include a first electrode; a second electrode; and an organic layer disposed between the first electrode and the second electrode, the organic layer including an emission layer and at least one organometallic compound represented by Formula 1.

Since the organic light-emitting device includes an organic layer including the organometallic compound represented by Formula 1, the organic light-emitting device may have excellent quantum emission efficiency, excellent emission efficiency, and/or long lifespan.

The organometallic compound represented by Formula 1 may be used in a pair of electrodes in an organic light-emitting device. For example, the organometallic compound represented by Formula 1 may be included in the emission layer. In this embodiment, the organometallic compound may serve as a dopant and the emission layer may further include a host (that is, an amount of the organometallic compound represented by Formula 1 may be smaller than that of the host).

A horizontal orientation ratio of a transition dipole moment of the organometallic compound with respect to a plane of the emission layer may be in a range of about 85% to about 100%, for example, about 86% to about 100%, about 87% to about 100%, about 88% to about 100%, about 89% to about 100%, about 90% to about 100%, about 91% to about 100%, about 92% to about 100%, about 93% to about 100%, about 94% to about 100%, about 95% to about 100%, about 96% to about 100%, about 97% to about 100%, about 98% to about 100%, or about 99% to about 100%, or about 100%, but embodiments are not limited thereto.

In some embodiments, a horizontal orientation ratio of a transition dipole moment of the organometallic compound included in the emission layer with respect to a plane of the emission layer may be in a range of about 85% to about 95%, for example, about 87% to about 92%, but embodiments are not limited thereto.

As used herein, "(for example, the organic layer) including at least one organometallic compound" means that "(the organic layer) including one organometallic compound of Formula 1, or at least two different organometallic compounds of Formula 1".

For example, Compound 1 may only be included in the organic layer as an organometallic compound. In this embodiment, Compound 1 may be included in the emission layer of the organic light-emitting device. In some embodiments, Compounds 1 and 2 may be included in the organic layer as organometallic compounds. In this embodiment, Compounds 1 and 2 may both be included in the same layer (for example, both Compounds 1 and 2 may be included in the emission layer).

The first electrode is anode, which is a hole injection electrode, and the second electrode is a cathode, which is an electron injection electrode. In some embodiments, the first electrode is a cathode, which is an electron injection electrode, and the second electrode is an anode, which is a hole injection electrode.

For example, in the organic light-emitting device, the first electrode may be an anode, the second electrode may be a cathode, and the organic layer may further include a hole transport region disposed between the first electrode and the emission layer and an electron transport region disposed between the emission layer and the second electrode, wherein the hole transport region may include a hole injection layer, a hole transport layer, an electron blocking layer, or a combination thereof, and the electron transport region may include a hole blocking layer, an electron transport layer, an electron injection layer, or a combination thereof.

The term the "organic layer" as used herein refers to a single and/or a plurality of layers disposed between the first electrode and the second electrode in an organic light-emitting device. The "organic layer" may include not only organic compounds but also organometallic compounds including metals.

The FIGURE illustrates a schematic cross-sectional view of an organic light-emitting device 10 according to an embodiment. Hereinafter, a structure of an organic light-emitting device according to one or more embodiments and a method of manufacturing the organic light-emitting device will be described with reference to the FIGURE. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

The first electrode 11 may be formed by vacuum-depositing or sputtering, onto the substrate, a material for forming the first electrode 11. The first electrode 11 may be an anode. The material for forming the first electrode 11 may be selected from materials with a high work function for easy hole injection. The first electrode 11 may be a reflective electrode, a semi-transmissive electrode, or a transmissive electrode. The material for forming the first electrode 11 may be selected from indium tin oxide (ITO), indium zinc oxide (IZO), tin oxide (SnO₂), and zinc oxide (ZnO). In some embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In some embodiments, the first electrode 11 may have a triple-layered structure of ITO/Ag/ITO, but embodiments are not limited thereto.

The organic layer 15 may be on the first electrode 11.

The organic layer 15 may include a hole transport region, an emission layer, and an electron transport region.

The hole transport region may be disposed between the first electrode 11 and the emission layer.

The hole transport region may include at least one selected from a hole injection layer, a hole transport layer, an electron blocking layer, and a buffer layer. The hole transport layer may be a single layer, or a multi-layer including at least two layers.

The hole transport region may include a hole injection layer only or a hole transport layer only. In some embodiments, the hole transport region may have a hole injection layer/hole transport layer structure, a hole injection layer/hole transport layer/electron blocking layer structure, a hole transport layer/electron blocking layer structure, a hole injection layer/first hole transport layer/second hole transport layer structure, a hole injection layer/first hole transport layer/second hole transport layer/electron blocking layer structure, or a first hole transport layer/second hole transport layer/electron blocking layer structure, wherein layers of each structure are sequentially stacked on the first electrode 11 in each stated order.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum-deposition, for example, the vacuum deposition may be performed at a temperature in a range of about 100°C to about 500°C, at a vacuum degree in a range of about 10⁻⁸ torr to about 10⁻³ torr, and at a rate in a range of about 0.01 Angstroms per second (Å/sec) to about 100 Å/sec, though the conditions may vary depending on a compound used as a hole injection material and a structure and thermal properties of a desired hole injection layer, but embodiments are not limited thereto.

When a hole injection layer is formed by spin coating, the spin coating may be performed at a rate in a range of about 2,000 revolutions per minute (rpm) to about 5,000 rpm and at a temperature in a range of about 80°C to 200°C to facilitate removal of a solvent after the spin coating, though the conditions may vary depending on a compound used as a hole injection material and a structure and thermal properties of a desired hole injection layer, but embodiments are not limited thereto.

The conditions for forming a hole transport layer and an electron blocking layer may be inferred from the conditions for forming the hole injection layer.

The hole transport region may include at least one selected from m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), (polyaniline)/poly(4-styrene sulfonate) (PANI/PSS), a compound represented by Formula 201, and a compound represented by Formula 202: 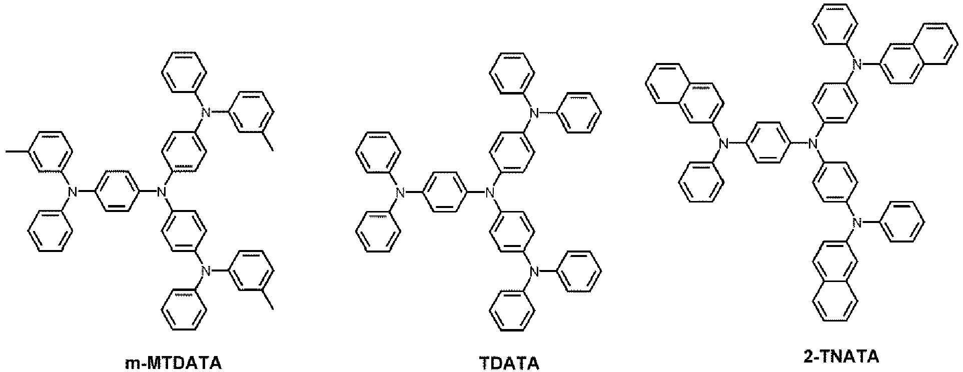 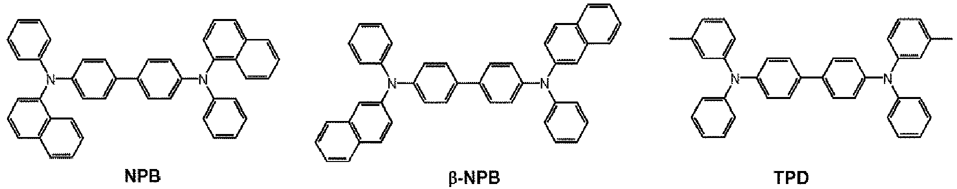 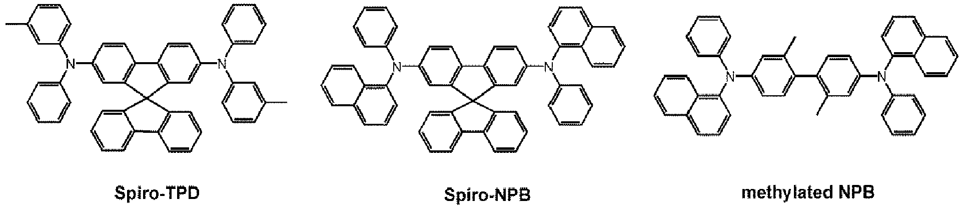 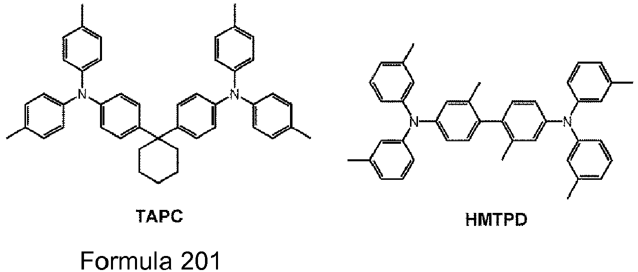 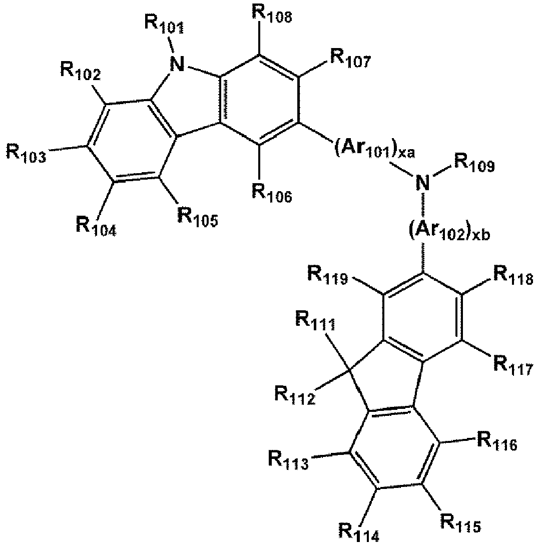 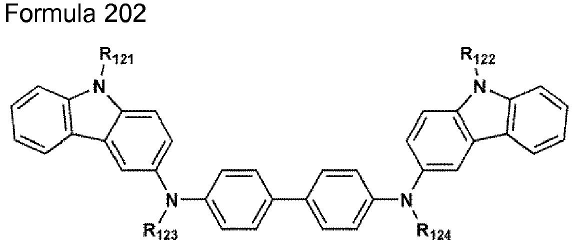 wherein, in Formula 201, Ar₁₀₁ and Ar₁₀₂ may each independently be selected from:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

In Formula 201, xa and xb may each independently be an integer from 0 to 5. In some embodiments, xa and xb may each independently be an integer selected from 0, 1, and 2. In some embodiments, xa may be 1, and xb may be 0, but embodiments are not limited thereto.

In Formulae 201 and 202, R₁₀₁ to R₁₀₈, R₁₁₁ to R₁₁₉, and R₁₂₁ to R₁₂₄ may each independently be selected from:
hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, pentyl group, or a hexyl group), and a C₁-C₁₀ alkoxy group (e.g., a methoxy group, an ethoxy group, a propoxy group, a butoxy group, or a pentoxy group);
a C₁-C₁₀ alkyl group and a C₁-C₁₀ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group, but embodiments are not limited thereto.

In Formula 201, R₁₀₉ may be selected from:
a phenyl group, a naphthyl group, an anthracenyl group, and a pyridinyl group; and
a phenyl group, a naphthyl group, an anthracenyl group, and a pyridinyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group and a pyridinyl group.

In some embodiments, the compound represented by Formula 201 may be represented by Formula 201A, but embodiments are not limited thereto:

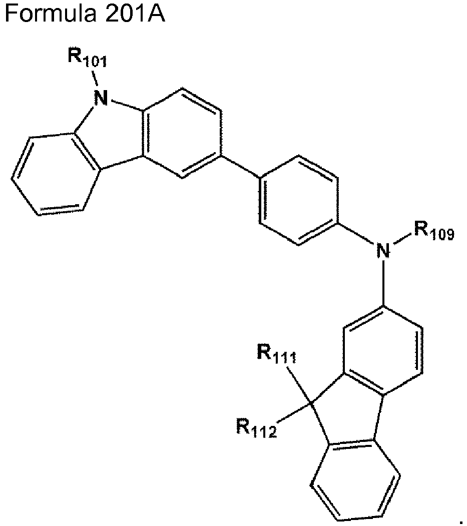

R₁₀₁, R₁₁₁, R₁₁₂, and R₁₀₉ in Formula 201A may be the same as those described above.

In some embodiments, the compounds represented by Formulae 201 and 202 may include Compounds HT1 to HT20, but embodiments are not limited thereto:

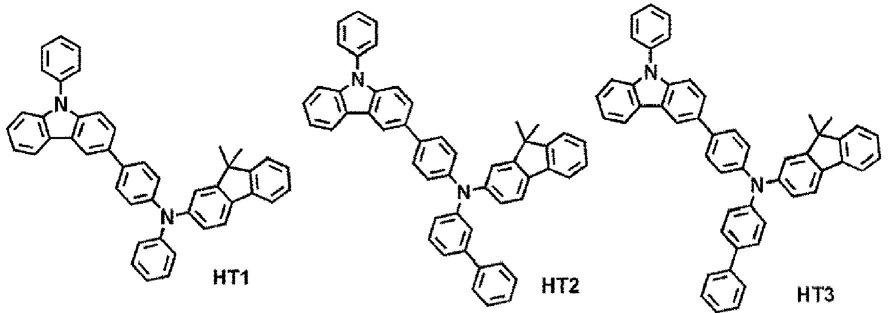

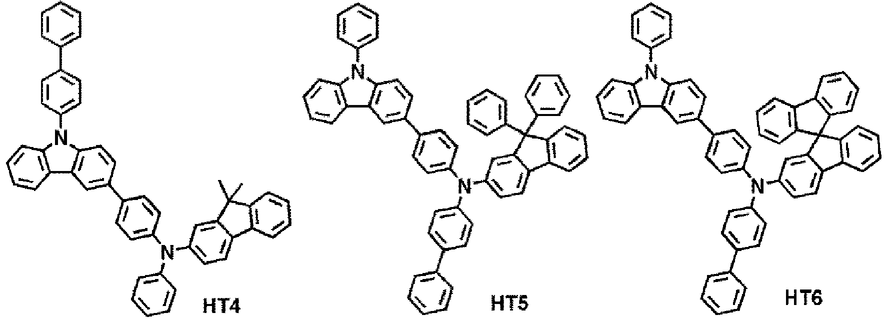

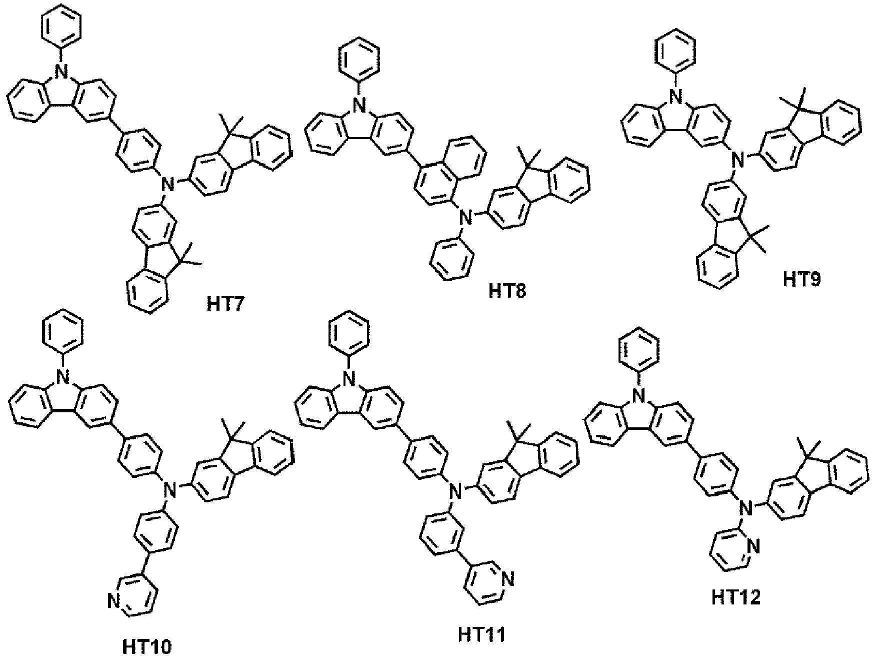

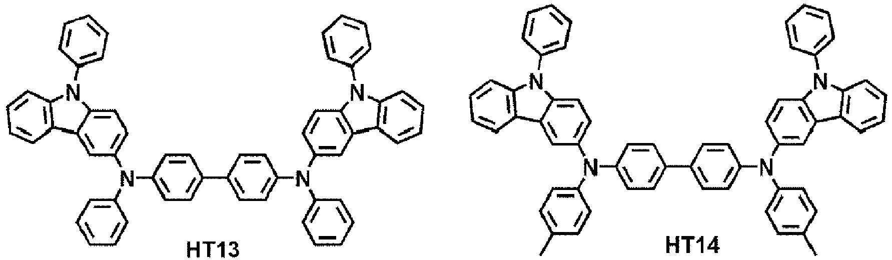

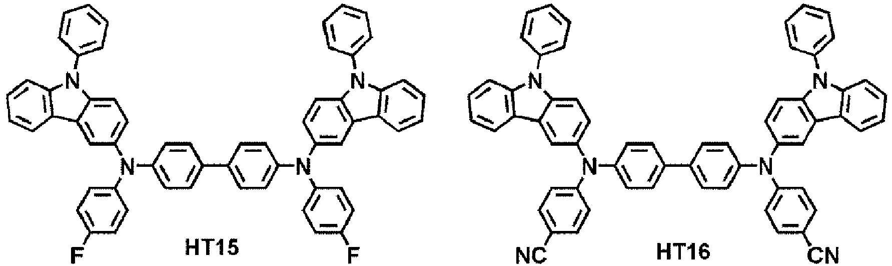

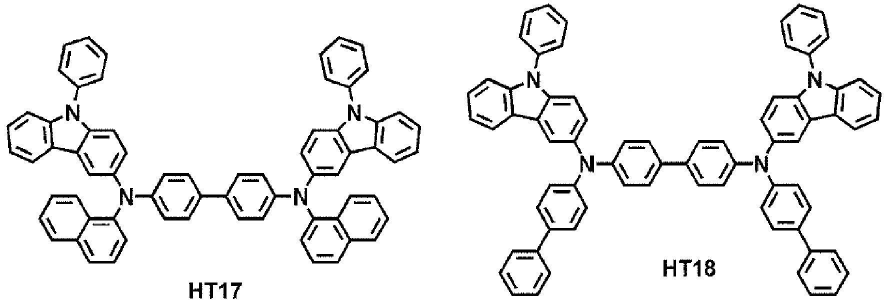

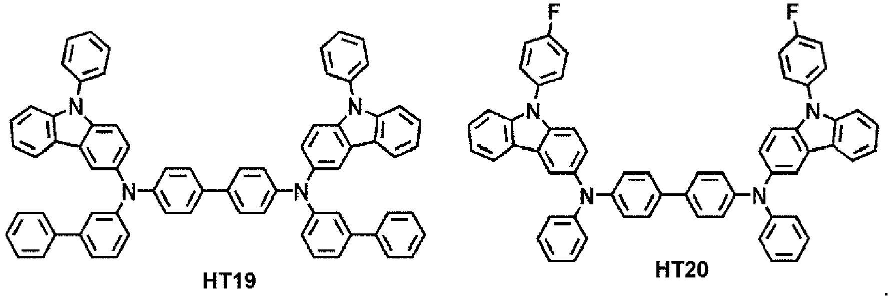

The thickness of the hole transport region may be in a range of about 100 Angstroms (Å) to about 10,000 Å, for example, about 100 Å to about 1,000 Å. When the hole transport region includes a hole injection layer and a hole transport layer, the thickness of the hole injection layer may be in a range of about 100 Å to about 10,000 Å, for example, about 100 Å to about 1,000 Å, a thickness of the hole transport layer may be in a range of about 50 Å to about 2,000 Å, for example, about 100 Å to about 1,500 Å. While not wishing to be bound by theory, it is understood that when the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may include one of a quinone derivative, a metal oxide, and a compound containing a cyano group, but embodiments are not limited thereto. For example, non-limiting examples of the p-dopant include a quinone derivative, such as tetracyanoquinodimethane (TCNQ) or 2,3,5,6-tetrafluoro-7,7,8,8-tetracyano-1,4-benzoquinonedimethane (F4-TCNQ); a metal oxide, such as a tungsten oxide or a molybdenum oxide; and a compound containing a cyano group, such as Compound HT-D1 or Compound HT-D2, but embodiments are not limited thereto:

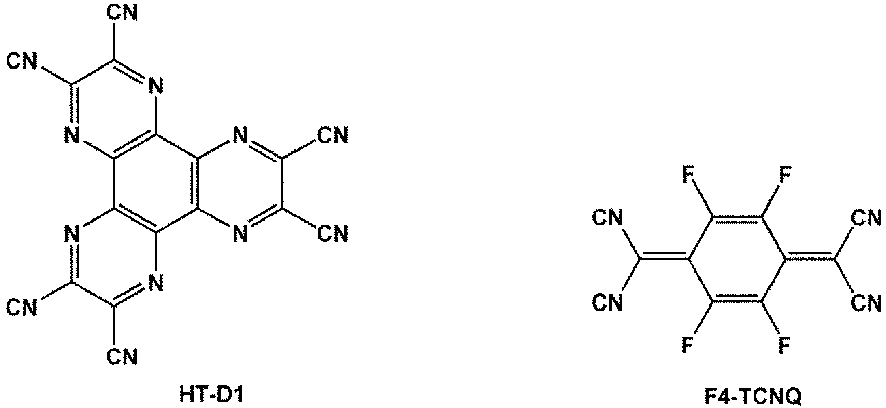

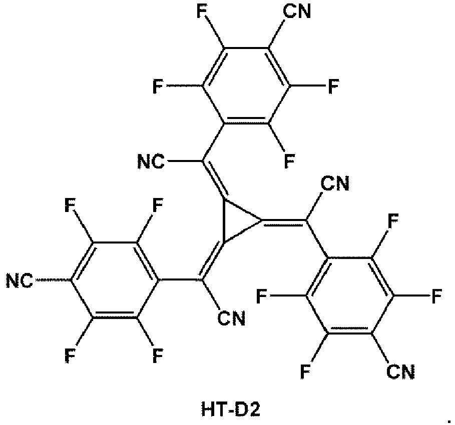

The hole transport region may further include a buffer layer.

The buffer layer may compensate for an optical resonance distance depending on a wavelength of light emitted from the emission layer to improve the efficiency of an organic light-emitting device.

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to the those conditions for forming a hole injection layer, though the conditions may vary depending on a compound that is used.

When the hole transport region includes an electron blocking layer, a material for forming the electron blocking layer may be selected from the materials for forming a hole transport region and host materials described herein, but embodiments are not limited thereto. In some embodiments, when the hole transport region includes an electron blocking layer, mCP described herein may be used for forming the electron blocking layer.

The emission layer may include a host and a dopant, and the dopant may include the organometallic compound represented by Formula 1.

Any suitable host material may be used as a host. The host may be composed of one kind of compound or a composition of two different kinds of compounds.

The host may include, for example, at least one selected from TPBi, TBADN, ADN (also known as "DNA"), CBP, CDBP, TCP, mCP, and Compounds H50 and H51:

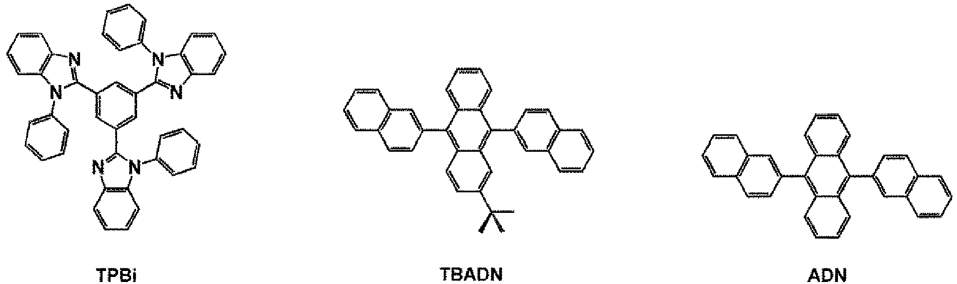

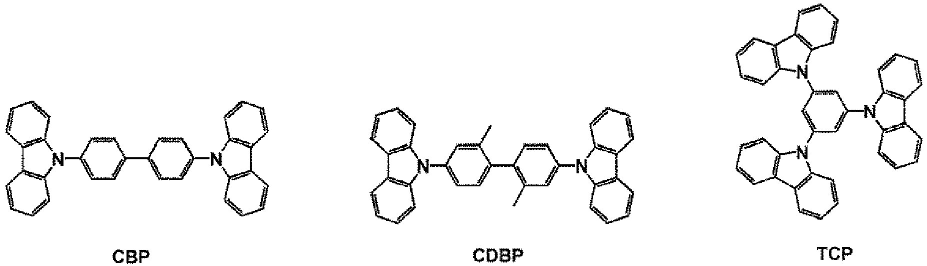

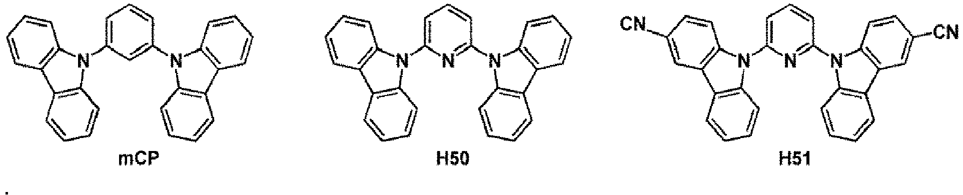

In some embodiments, the host may include at least one of compounds including at least one selected from a carbazole group, a fluorene group, a spirobifluorene group, a dibenzofuran group, a dibenzothiophene group, a dibenzosilole group, an indenocarbazole group, an indolocarbazole group, a benzofurocarbazole group, a benzothienocarbazole group, an acridine group, a dihydroacridine group, a triindolobenzene group, an azadibenzofuran group, an azadibenzothiophene group, an azacarbazole group, an azafluorene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a phenazine group, a cinnoline group, a cyano group, a phosphine oxide group, and a sulfoxide group.

The host may be a composition including two different kinds of compounds selected from among the foregoing compounds.

For example, the host may include a hole transport host (a host not including an electron transport moiety) and an electron transport host (a host including an electron transport moiety).

When the organic light-emitting device 10 is a full-color organic light-emitting device, the emission layer may be patterned into a red emission layer, a green emission layer, and a blue emission layer. In some embodiments, the emission layer may have a structure in which the red emission layer, the green emission layer, and/or the blue emission layer are layered to emit white light. In some embodiments, the structure of the emission layer may vary.

When the emission layer includes the host and the dopant, an amount of the dopant may be selected from a range of about 0.01 parts to about 15 parts by weight based on about 100 parts by weight of the host, but embodiments are not limited thereto.

The thickness of the emission layer may be in a range of about 100 Å to about 1,000 Å, and in some embodiments, about 200 Å to about 600 Å. While not wishing to be bound by theory, it is understood that when the thickness of the emission layer is within any of these ranges, improved luminous characteristics may be obtained without a substantial increase in driving voltage.

Next, an electron transport region may be formed on the emission layer.

The electron transport region may include at least one selected from a hole blocking layer, an electron transport layer, and an electron injection layer, but embodiments not limited thereto.

In some embodiments, the electron transport region may have a hole blocking layer/an electron transport layer/an electron injection layer structure or an electron transport layer/an electron injection layer structure, but embodiments are not limited thereto. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer may include, for example, at least one selected from BCP, Bphen, and BAlq, but embodiments are not limited thereto:

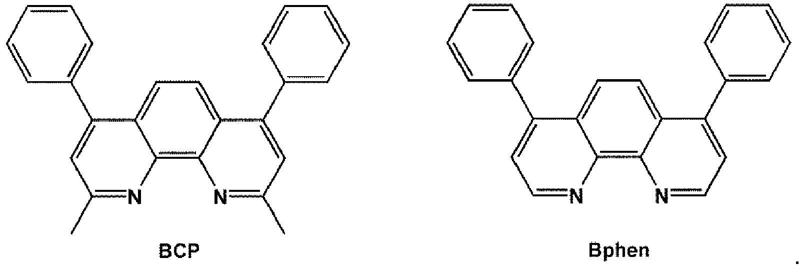

The thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, excellent hole blocking characteristics may be obtained without a substantial increase in driving voltage.

The electron transport layer may further include at least one selected from BCP, BPhen, Alq₃, BAlq, TAZ, and NTAZ:

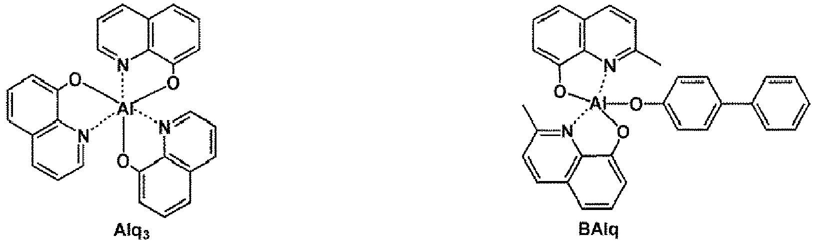

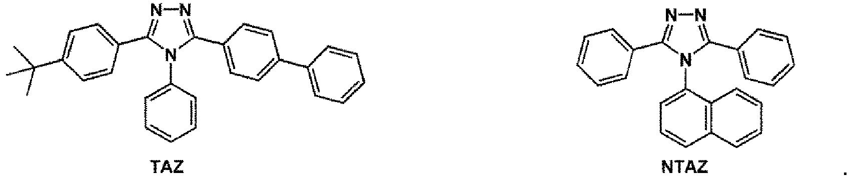

Alternatively, the electron transport layer may include at least one selected from Compounds ET1 to ET19, but embodiments are not limited thereto:

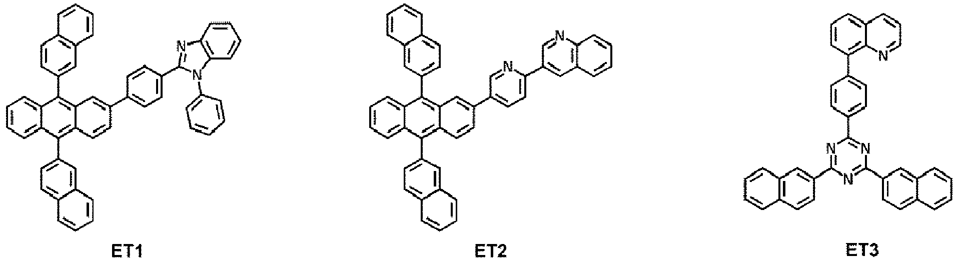

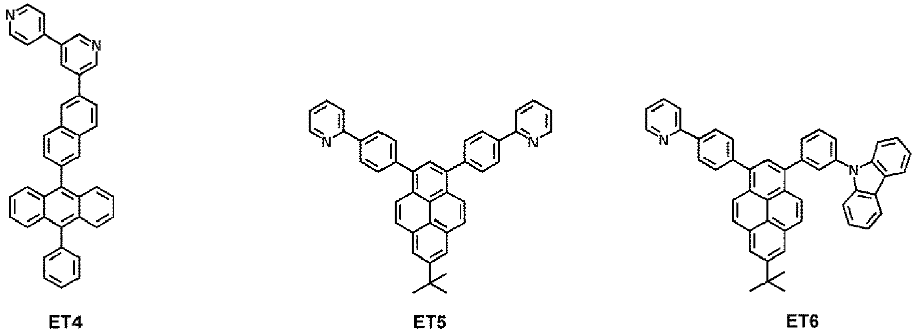

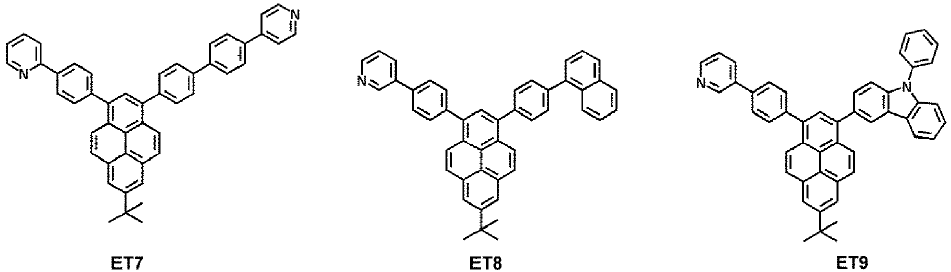

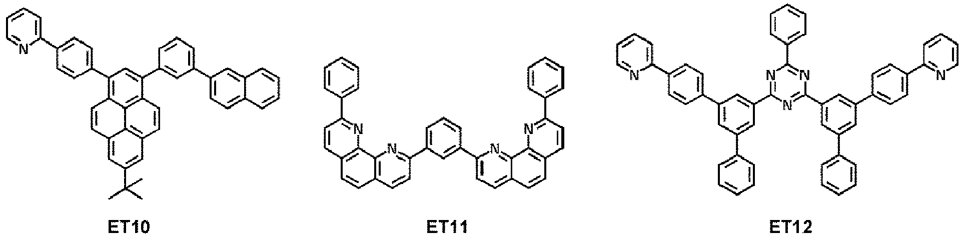

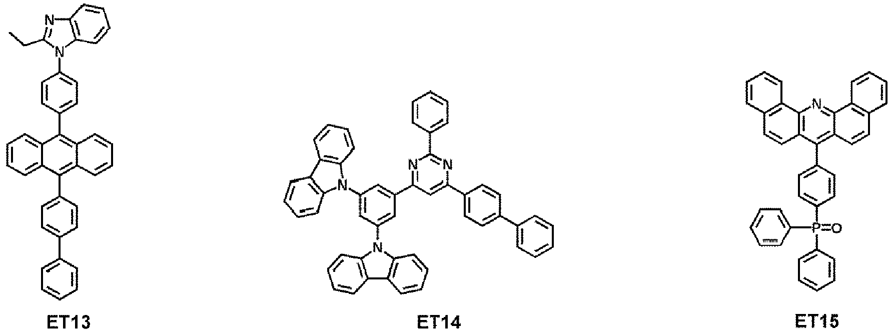

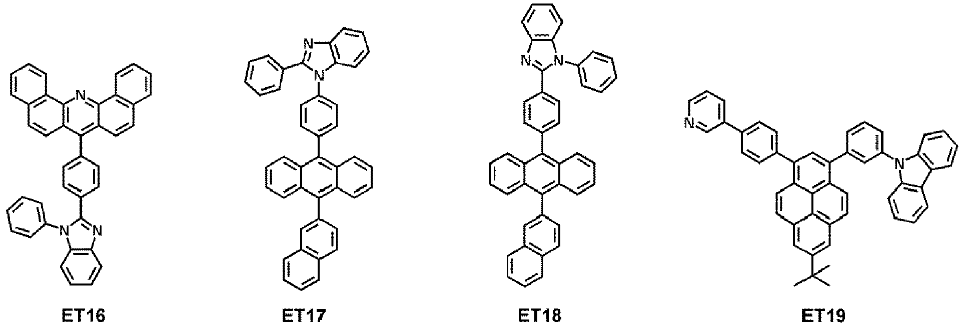

The thickness of the electron transport layer may be in a range of about 100 Å to about 1,000 Å, and in some embodiments, about 150 Å to about 500 Å. While not wishing to be bound by theory, it is understood that when the thickness of the electron transport layer is within any of these ranges, excellent electron transport characteristics may be obtained without a substantial increase in driving voltage.

The electron transport layer may further include a material containing metal, in addition to the materials described above.

The material containing metal may include a lithium (Li) complex. The Li complex may include, *e.g.,* Compound ET-D1 (lithium 8-hydroxyquinolate, LiQ) or Compound ET-D2:

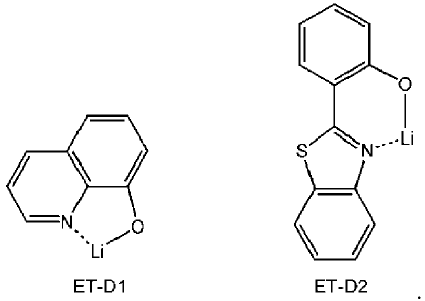

The electron transport region may include an electron injection layer that facilitates electron injection from the second electrode 19.

The electron injection layer may include at least one selected from LiF, NaCl, CsF, Li₂O, and BaO.

The thickness of the electron injection layer may be in a range of about 1 Å to about 100 Å, and in some embodiments, about 3 Å to about 90 Å. While not wishing to be bound by theory, it is understood that when the thickness of the electron injection layer is within any of these ranges, excellent electron injection characteristics may be obtained without a substantial increase in driving voltage.

The second electrode 19 may be formed on the organic layer 15. The second electrode 19 may be a cathode. A material for forming the second electrode 19 may be a material with a relatively low work function, such as a metal, an alloy, an electrically conductive compound, and a mixture thereof. Examples of the material for forming the second electrode 19 may include lithium (Li), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore the organic light-emitting device 10 has been described with reference to the FIGURE, but embodiments are not limited thereto.

The term "C₁-C₆₀ alkyl group" as used herein refers to a linear or branched aliphatic saturated hydrocarbon monovalent group having 1 to 60 carbon atoms. Examples thereof include a methyl group, an ethyl group, a propyl group, an isobutyl group, a sec-butyl group, a tert-butyl group, a pentyl group, an iso-amyl group, and a hexyl group. The term "C₁-C₆₀ alkylene group" as used herein refers to a divalent group having substantially the same structure as the C₁-C₆₀ alkyl group.

The term "C₁-C₆₀ alkoxy group" as used herein refers to a monovalent group represented by -OA₁₀₁ (wherein A₁₀₁ is a C₁-C₆₀ alkyl group). Examples thereof include a methoxy group, an ethoxy group, and an isopropyloxy group.

The term "C₂-C₆₀ alkenyl group" as used herein refers to a group formed by placing at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having substantially the same structure as the C₂-C₆₀ alkenyl group.

The term "C₂-C₆₀ alkynyl group" as used herein refers to a group formed by placing at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having substantially the same structure as the C₂-C₆₀ alkynyl group.

The term "C₃-C₁₀ cycloalkyl group" as used herein refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a saturated monovalent monocyclic group including at least one heteroatom selected from N, O, P, Si, and S as a ring-forming atom and 1 to 10 carbon atoms. Examples thereof include a tetrahydrofuranyl group and a tetrahydrothiophenyl group. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent monocyclic group including 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent monocyclic group including at least one heteroatom selected from N, O, P, Si, and S as a ring-forming atom, 1 to 10 carbon atoms, and at least one double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and a C₆-C₆₀ arylene group each include at least two rings, the at least two rings may be fused.

The term "C₁-C₆₀ heteroaryl group" as used herein refers to a monovalent group having a heterocyclic aromatic system having at least one heteroatom selected from N, O, P, Si, and S as a ring-forming atom and 1 to 60 carbon atoms. The term "C₁-C₆₀ heteroarylene group" as used herein refers to a divalent group having a heterocyclic aromatic system having at least one heteroatom selected from N, O, P, Si and S as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include at least two rings, the at least two rings may be fused.

The term "C₆-C₆₀ aryloxy group" as used herein indicates -OA₁₀₂ (wherein A₁₀₂ is a C₆-C₆₀ aryl group). The term "C₆-C₆₀ arylthio group" as used herein indicates -SA₁₀₃ (wherein A₁₀₃ is a C₆-C₆₀ aryl group).

The term "monovalent non-aromatic condensed polycyclic group" as used herein refers to a monovalent group that has two or more condensed rings and only carbon atoms (*e.g.,* the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings, and a heteroatom selected from N, O, P, Si, and S and carbon atoms (*e.g.,* the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. Depending on formula structure, the C₅-C₃₀ carbocyclic group may be monovalent, divalent, trivalent, quadrivalent, pentavalent, or hexavalent.

The term "C₁-C₃₀ heterocyclic group" as used herein refers to saturated or unsaturated cyclic group including 1 to 30 carbon atoms and at least one heteroatom selected from N, O, P, Si, and S as ring-forming atoms. The C₁-C₃₀ heterocyclic group may be a monocyclic group or a polycyclic group. Depending on formula structure, the C₅-C₃₀ heterocyclic group may be monovalent, divalent, trivalent, quadrivalent, pentavalent, or hexavalent.

In the present specification, at least one substituent of the substituted C₅-C₃₀ carbocyclic group, substituted C₁-C₃₀ heterocyclic group, substituted C₁-C₆₀ alkyl group, substituted C₂-C₆₀ alkenyl group, substituted C₂-C₆₀ alkynyl group, substituted C1-C60 alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₇-C₆₀ arylalkyl group, substituted C₁-C₆₀ heteroaryl group, substituted C₁-C₆₀ heteroaryloxy group, substituted C₁-C₆₀ heteroarylthio group, substituted C₂-C₆₀ heteroarylalkyl group, substituted monovalent non-aromatic condensed polycyclic group, and substituted monovalent non-aromatic condensed heteropolycyclic group may be selected from:
deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -B(Q₁₆)(Q₁₇), and-P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C6-C60 aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C6-C60 aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group, each substituted with at least one selected from deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C6-C60 aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉), wherein Q₁ to Q₉, Q₁₁ to Q₁₉, Q₂₁ to Q₂₉, and Q₃₁ to Q₃₉ may each independently be selected from hydrogen, deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group and a C₆-C₆₀ aryl group, a C6-C60 aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used in terms of molar equivalents.

### EXAMPLES

### Synthesis Example 1: Synthesis of Compound 1

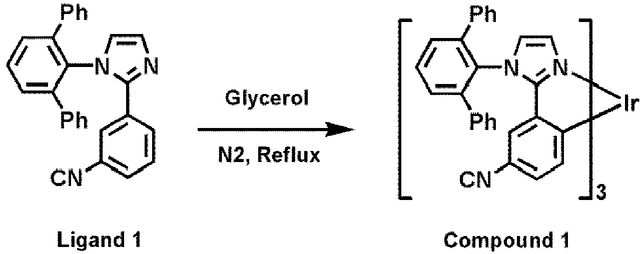

3.29 millimoles (mmol) of Ir(acac)₃, 16.47 mmol of Ligand 1, and glycerol were added to a reaction vessel. Next, the mixture was refluxed for 12 hours under nitrogen atmosphere. Once the reaction was complete, the mixture was cooled to room temperature. Dichloromethane and distilled water were added thereto, and the organic layer was separated. The obtained organic layer was washed with distilled water two times and dried with magnesium sulfate (MgSO₄) to remove moisture therefrom. The resultant mixture was filtered and evaporated to remove the organic solvent. The obtained crude product was purified through silica gel column chromatography (using dichloromethane and n-hexane as an eluent) to obtain 0.51 mmol of Compound 1. The structure and purity (greater than 99%) of Compound 1 were identified by using nuclear magnetic resonance (NMR), high-performance liquid chromatography (HPLC), and liquid chromatography-mass spectrometry (LCMS).

¹H-NMR (300 MHz, CD₂Cl₂) δ 7.8 (1H, t), 7.7-7.55(2H, m), 7.1-6.7(10.5H, m), 6.6(1H, s), 6.55-6.4 (2H, m)

### Synthesis Example 2: Synthesis of Compound 2

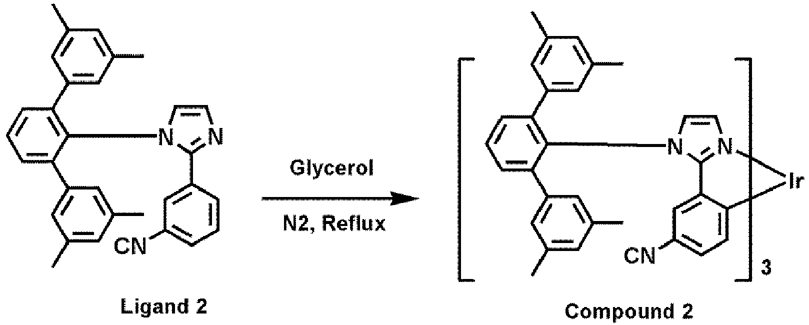

0.3 grams (g) of Compound 2 (having a purity of 99.83%) was obtained in substantially the same manner as in Synthesis Example 1, except that Ligand 2 was used instead of Ligand 1.

LC-MS (calculated value: 1,381.14 grams per mole (g/mol), measured value: M⁺¹ = 1,382 g/mol)

### Synthesis Example 3: Synthesis of Compound 3

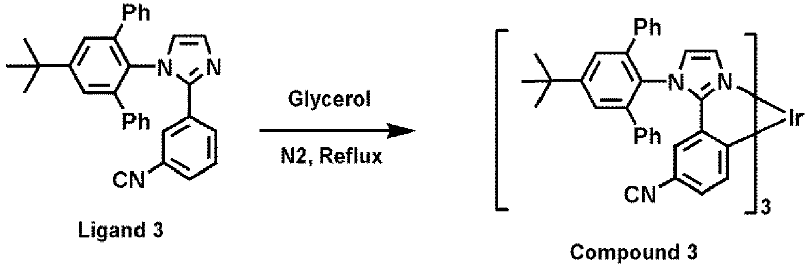

0.51 mmol of Compound 3 was obtained in substantially the same manner as in Synthesis Example 1, except that Ligand 3 was used instead of Ligand 1. The structure and purity (greater than 99%) of Compound 3 were identified by using NMR, HPLC, and LCMS.

¹H-NMR (300 MHz, CD₂Cl₂) δ 7.65 (1H, s), 7.56(1H, s), 7.2-7.0(3H, m), 6.9-6.6 (8H, m), 5.4 (1H, s), 1.47(9H, s)

### Synthesis Example 4: Synthesis of Compound 4

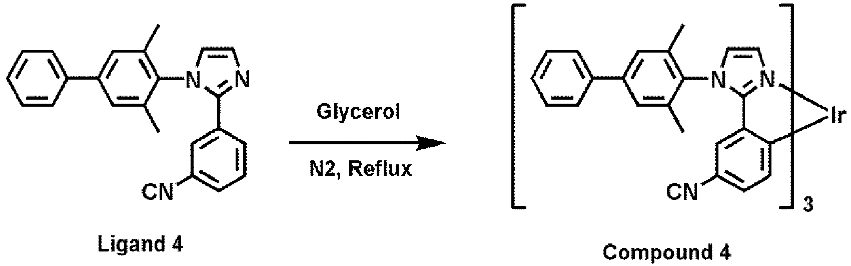

0.3 g of Compound 4 (having a purity of 99.03%) was obtained in substantially the same manner as in Synthesis Example 1, except that Ligand 4 was used instead of Ligand 1.

LC-MS (calculated value: 1,237.41 g/mol, measured value: M⁺¹ = 1,238 g/mol)

### Synthesis Example 5: Synthesis of Compound 5

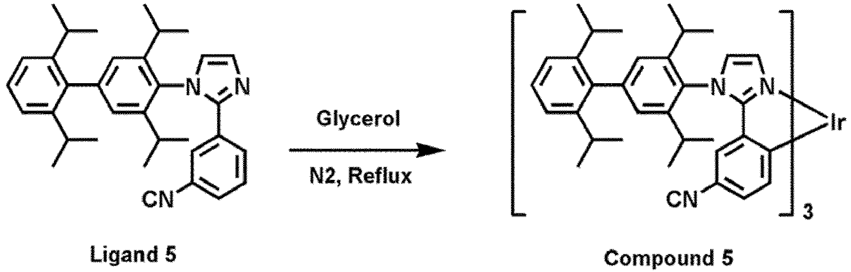

0.37 g of Compound 5 (having a purity of 98.3%) was obtained in substantially the same manner as in Synthesis Example 1, except that Ligand 5 was used instead of Ligand 1.

LC-MS (calculated value: 1,657.88 g/mol, measured value: M⁺¹ = 1,658 g/mol)

### Synthesis Example 6: Synthesis of Compound 6

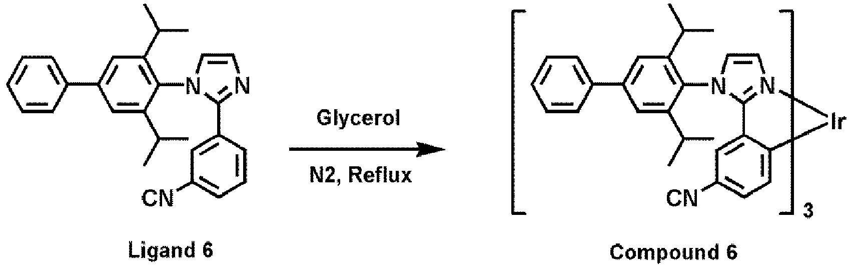

0.23 g of Compound 6 (having a purity of 99.2%) was obtained in substantially the same manner as in Synthesis Example 1, except that Ligand 6 was used instead of Ligand 1.

LC-MS (calculated value: 1,405.60 g/mol, measured value: M⁺¹ = 1,406 g/mol)

### Synthesis Example 7: Synthesis of Compound 7

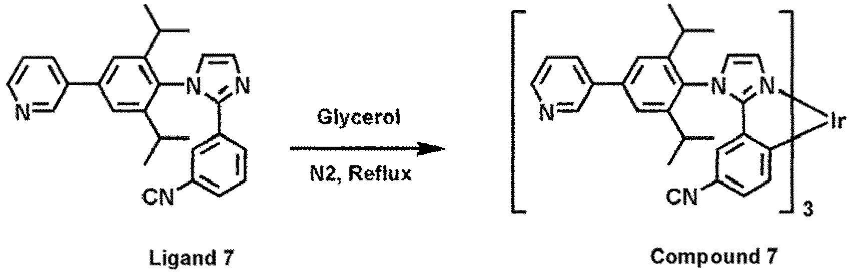

0.17 g of Compound 7 (having a purity of 99.7%) was obtained in substantially the same manner as in Synthesis Example 1, except that Ligand 7 was used instead of Ligand 1.

LC-MS (calculated value: 1,408.59 g/mol, measured value: M⁺¹ = 1,409 g/mol)

### Synthesis Example 8: Synthesis of Compound 8

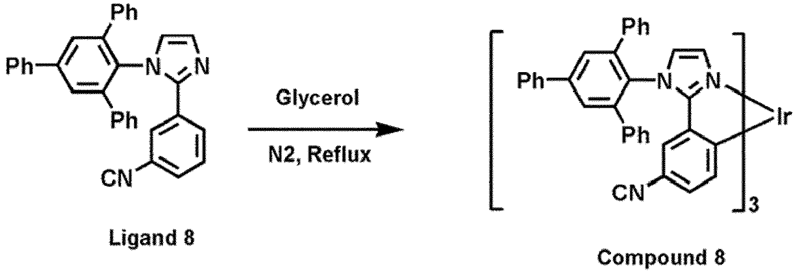

0.48 mmol of Compound 8 was obtained in substantially the same manner as in Synthesis Example 1, except that Ligand 8 was used instead of Ligand 1. The structure and purity (greater than 99%) of Compound 8 were identified by using NMR, HPLC, and LCMS.

¹H-NMR (300 MHz, CD₂Cl₂) δ 7.8 (1H, s), 7.7(2H, d), 7.6-7.5(2H, m), 7.5-7.4(1H, m), 7.1-7.0 (3H, t), 7.0-6.9(5H, m), 6.9-6.8(4H, m), 6.55 (1H, s), 6.5-6.4(1H, m), 5.5(1H,s)

### Synthesis Example 9: Synthesis of Compound 9

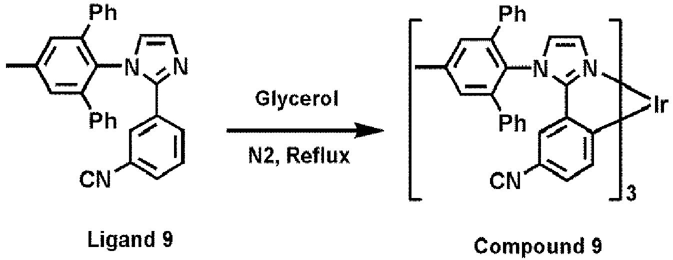

0.50 mmol of Compound 9 was obtained in substantially the same manner as in Synthesis Example 1, except that Ligand 9 was used instead of Ligand 1. The structure and purity (greater than 99%) of Compound 9 were identified by using NMR, HPLC, and LCMS.

¹H-NMR (300 MHz, CD₂Cl₂) δ 7.50 (1H, s), 7.45(1H, s), 7.15-6.88(3H, m), 6.86-6.84(3H, m), 6.82-6.72 (5H, m), 6.68(1H, s), 6.46-6.42(2H, m), 5.46 (1H, s), 2.59(3H, s)

### Evaluation Example 1: Evaluation of Horizontal Orientation Ratio

In a vacuum deposition device, mCP and Compound 1 were co-deposited at a weight ratio of 92:8 (Compound 1 being 8 percent by weight, wt%) onto a fused silica substrate layer (having a thickness of 1 millimeter (mm)) at a vacuum degree of 1×10⁻⁷ torr, thereby preparing Sample 1 having a thickness of 30 nanometers (nm). The structure was then sealed by using glass and glue under a nitrogen atmosphere. Substantially the same process was performed using each of Compounds 2 to 9, A to D, and F to thereby prepare Samples 2 to 9, A to D, and F, respectively.

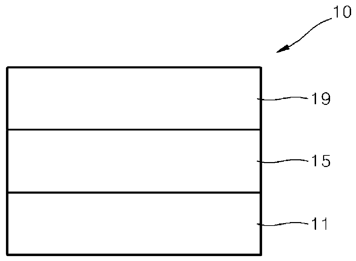

Here, an angle-dependent PL measuring device having a structure as shown in FIG. 3 of Korean Patent Application No. 2013-0150834 was prepared. The detailed specification of the device is as follows:
- Excited light wavelength: 325 nanometers (nm)
- Excited light source: He-Cd laser available from Melles Griot
- Excited light irradiator: Optical fiber having a diameter of 1 mm available from Thorlabs
- Semicylindrical prism: Fused silica having a diameter of 100 mm and a length of 30 mm
- Emitted light detector: Photomultiplier tube available from Acton
- Polarizer mounted on the emission light detector: Linear polarizer available from Thorlabs
- Recorder: Spectrasense available from Acton
- Excited light incidence angle: θP = 45°, θH = 0°
- Distance from sample to the emitted light detector (or, a radius of moving route of the emitted light detector): 900 mm

Afterwards, Samples 1 to 9, A to D, and F were fixed on a semicylindrical lens, and irradiated with a 325 nm laser so as to cause light emission from each Sample. Emitted light passed through a polarization film, and then, in order to measure a p-polarized light emission intensity of 530 nm light within a range of 0 to 90 degrees, the semicylindrical lens, on which the sample was fixed, was rotated by 1 degree with respect to an axis of the semicylindrical lens by using a charge-coupled device (CCD).

The p-polarized light emission intensity (a first p-polarized light emission intensity) in a case where each compound is vertically aligned and the p-polarized light emission intensity (a second p-polarized light emission intensity) in a case where each compound is horizontally aligned were respectively calculated within a range of 0 to 90 degrees. The first p-polarized light emission intensity and the second p-polarized light emission intensity were respectively multiplied by a weight value such that the obtained total p-polarized light emission intensity was identical to the measured p-polarized light emission intensity, thereby obtaining a weight value. Then, the horizontal orientation ratio of each of Compounds 1 to 9, A to D, and F was measured. The results thereof are shown in Table 1. Here, the angle-dependent light emission spectrum was analyzed by using a classical dipole model in which emission from excitons is regarded as dissipated power from an oscillating dipole.

**Table 1**

| Sample No. | Co-deposition material | Horizontal orientation ratio (%) |
|---|---|---|
| 1 | mCP:Compound 1 (8 wt%) | 87 |
| 2 | mCP:Compound 2 (8 wt%) | 88 |
| 3 | mCP:Compound 3 (8 wt%) | 90 |
| 4 | mCP:Compound 4 (8 wt%) | 92 |
| 5 | mCP:Compound 5 (8 wt%) | 90 |
| 6 | mCP:Compound 6 (8 wt%) | 90 |
| 7 | mCP:Compound 7 (8 wt%) | 91 |
| 8 | mCP:Compound 8 (8 wt%) | 91 |
| 9 | mCP:Compound 9 (8 wt%) | 91 |
| A | mCP:Compound A (8 wt%) | 82 |
| B | mCP:Compound B (8 wt%) | 82 |
| C | mCP:Compound C (8 wt%) | 83 |
| D | mCP:Compound D (8 wt%) | 83 |
| F | mCP:Compound F (8 wt%) | 84 |

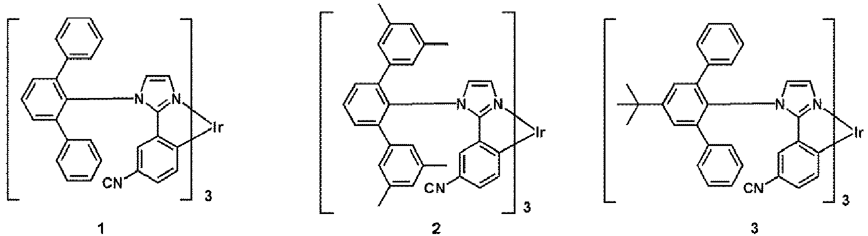

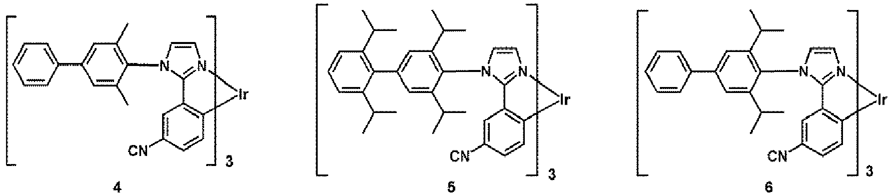

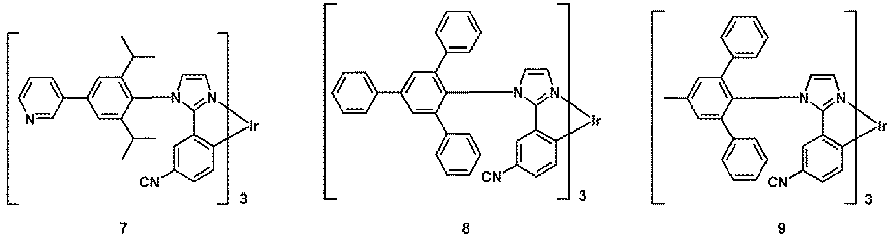

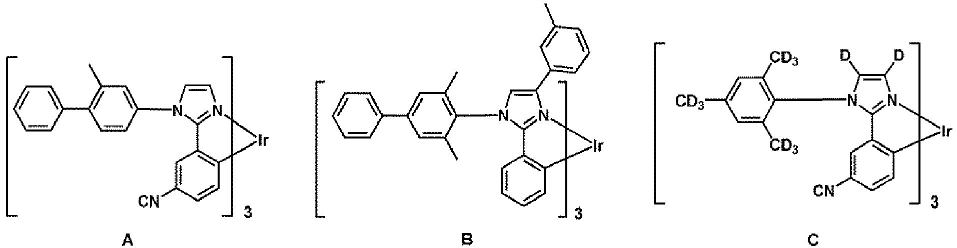

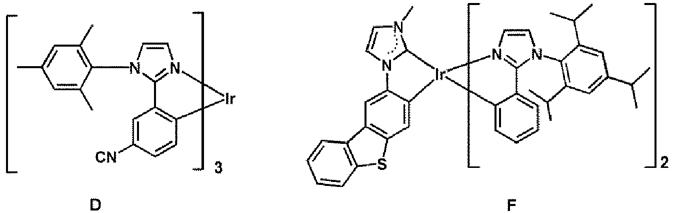

As it may be seen in Table 1, Compounds 1 to 9 were found to have excellent horizontal orientation ratios, *i.e.,* optical orientation in a horizontal direction, as compared with Compounds A to D and F.

### Example 1

A glass substrate having 1,500 Å thickness of indium tin oxide (ITO) electrode (first electrode, anode) deposited thereon was washed with distilled water in the presence of ultrasound waves. Once the washing with distilled water was complete, ultrasound wave washing was performed on the substrate by using iso-propyl alcohol, acetone, and methanol in this stated order. Subsequently, the substrate was dried, transferred to a plasma washer, washed for 5 minutes using oxygen plasma, and mounted in a vacuum deposition device.

Compound HT3 was vacuum-deposited on the ITO electrode of the glass substrate to form a first hole injection layer having a thickness of about 3,500 Å, Compound HT-D1 was vacuum-deposited on the first hole injection layer to form a second hole injection layer having a thickness of about 300 Å, and TAPC was vacuum-deposited on the second hole injection layer to form an electron blocking layer having a thickness of about 100 Å, thereby forming a hole transport region.

mCP (as a host) and Compound 1 (as a dopant, 7 wt%) were co-deposited on the hole transport region to form an emission layer having a thickness of about 300 Å.

Compound ET3 was vacuum-deposited on the emission layer to form an electron transport layer having a thickness of about 250 Å, ET-D1 (Liq) was deposited on the electron transport layer to form an electron injection layer having a thickness of about 5 Å, and an Al second electrode (a cathode) was formed on the electron injection layer to have a thickness of about 1,000 Å, thereby completing the manufacture of an organic light-emitting device.

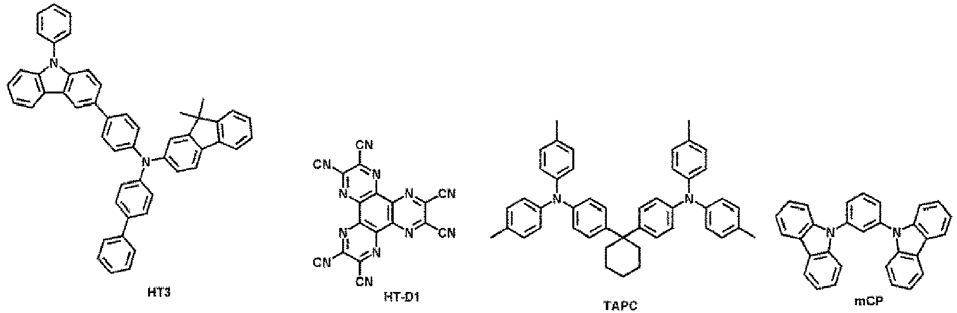

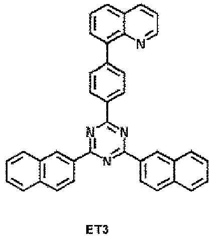

### Examples 2 to 9 and Comparative Examples A to F

Organic light-emitting devices were manufactured in substantially the same manner as in Example 1, except that the compounds shown in Table 2 were used instead of Compound 1 as a dopant in the formation of an emission layer.

### Evaluation Example 2: Evaluation of Characteristics of Organic light-emitting device

Emission color and maximum external quantum emission efficiency of the organic light-emitting devices manufactured in Examples 1 to 9 and Comparative Examples A to F were measured. The measurement method is as follows. The results thereof are shown in Table 2.

### (1) Emission Color

EL spectra of the manufactured organic light-emitting devices at a luminance of about 500 candelas per square meter (cd/m²) were measured by using a luminance meter (Minolta Cs-1000A).

### (2) Measurement of Maximum External Quantum Efficiency

The maximum external quantum emission efficiency was measured, based on the EL spectra measured in above item (1).

**Table 2**

| | Emission layer | | Color | Maximum external quantum emission efficiency (%) |
|---|---|---|---|---|
| | Host | Dopant | | |
| Example 1 | mCP | 1 | Blue | 24 |
| Example 2 | mCP | 2 | Blue | 24 |
| Example 3 | mCP | 3 | Blue | 26 |
| Example 4 | mCP | 4 | Blue | 26 |
| Example 5 | mCP | 5 | Blue | 28 |
| Example 6 | mCP | 6 | Blue | 26 |
| Example 7 | mCP | 7 | Blue | 26 |
| Example 8 | mCP | 8 | Blue | 26 |
| Example 9 | mCP | 9 | Blue | 24 |
| Comparative Example A | mCP | A | Blue | 21 |
| Comparative Example B | mCP | B | Blue | 20 |
| Comparative Example C | mCP | C | Blue | 22 |
| Comparative Example D | mCP | D | Blue | 21 |
| Comparative Example E | mCP | E | Blue | 22 |
| Comparative Example F | mCP | F | Blue | 21 |

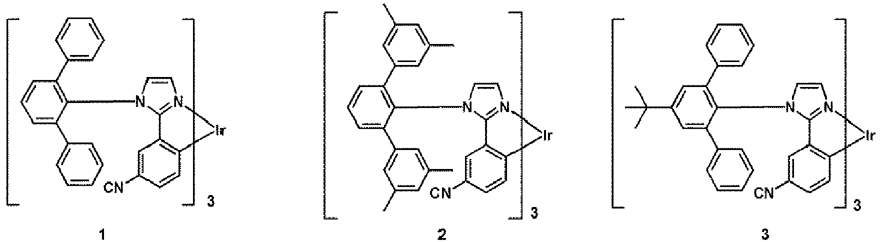

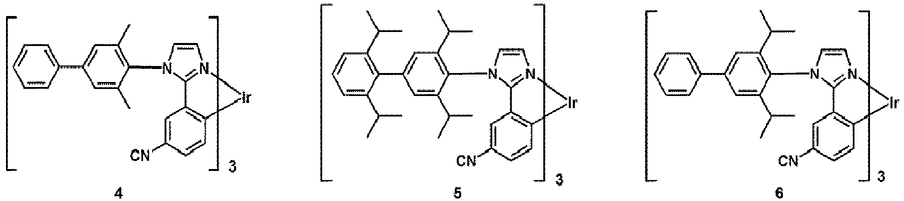

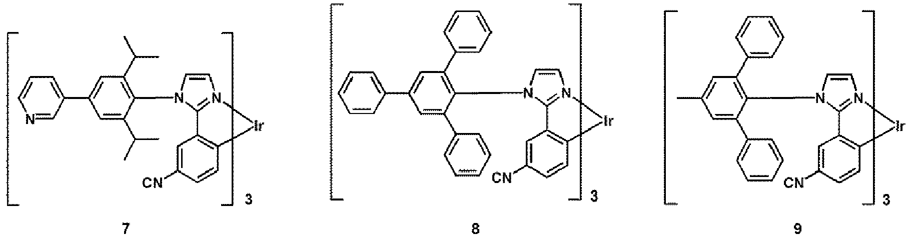

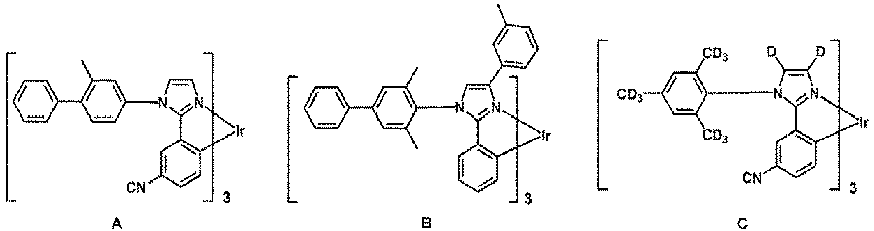

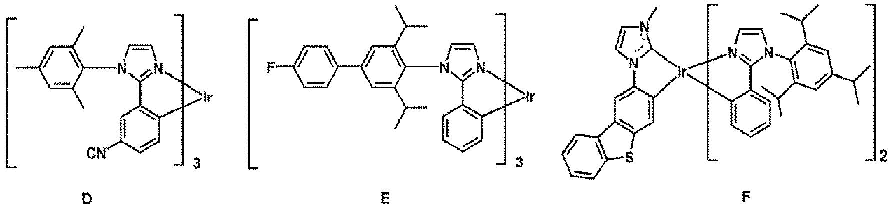

Referring to the results of Table 2, it was found that the organic light-emitting devices of Examples 1 to 9 emit blue light, and have improved maximum external quantum emission efficiency, as compared with the organic light-emitting devices manufactured in Comparative Examples A to F.

As apparent from the foregoing description, since the organometallic compound is a homoleptic complex having an anisotropic structure with an excellent optical orientation, the organometallic compound, which may be easily synthesized, may have excellent electrical characteristics and optical properties as well. Accordingly, an organic light-emitting device including the organometallic compound may have excellent driving voltage, current density, efficiency, electric power, color purity, and/or lifespan characteristics, with a relatively low production cost.

It should be understood that embodiments described herein should be considered in a descriptive sense only and not for purposes of limitation. Descriptions of features or aspects within each embodiment should typically be considered as available for other similar features or aspects in other embodiments.

While one or more embodiments have been described with reference to the figures, it will be understood by those of ordinary skill in the art that various changes in form and details may be made therein without departing from the scope of the present description as defined by the following claims.

## Claims

1. An organometallic compound represented by Formula 1, wherein the organometallic compound has a horizontal orientation ratio of a transition dipole moment in a range of 85 percent to 100 percent:
Formula 1 M(L₁)ₙ
wherein, in Formula 1,
M is selected from a first-row transition metal of the Periodic Table of Elements, a second-row transition metal of the Periodic Table of Elements, and a third-row transition metal of the Periodic Table of Elements,
n is 2 or 3,
L₁ is a bidentate organic ligand bound to M,
wherein L₁ does not comprise a fluoro group (-F), and
wherein L₁ groups in the number of n are identical to each other.

2. The organometallic compound of claim 1, wherein the horizontal orientation ratio of a transition dipole moment is in a range of 92 percent to 100 percent; and/or
wherein M is iridium or osmium, and n is 3; or M is platinum or palladium, and n is 2.

3. The organometallic compound of claims 1 or 2, represented by Formula 2: 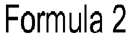 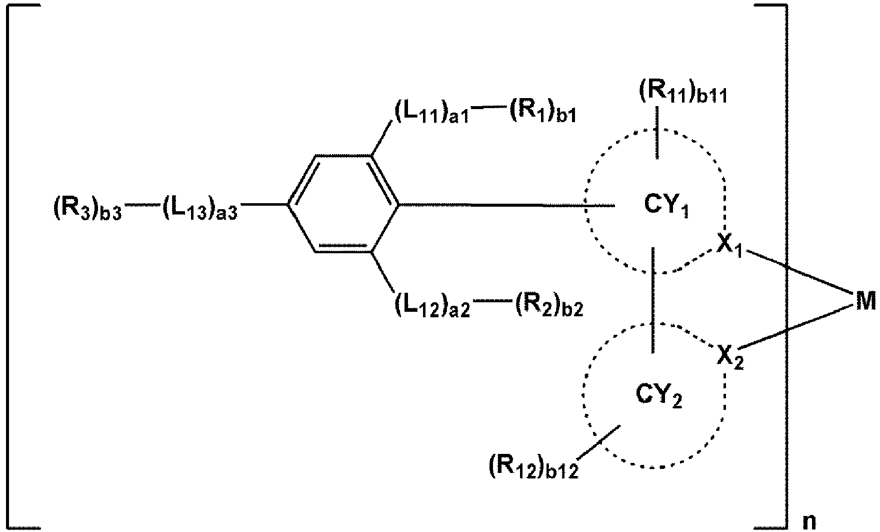 wherein, in Formula 2,
M is selected from a first-row transition metal of the Periodic Table of Elements, a second-row transition metal of the Periodic Table of Elements, and a third-row transition metal of the Periodic Table of Elements,
n is 2 or 3,
X₁ and X₂ are each independently C or N,
X₁ is bound to M via a covalent bond, and X₂ is bound to M via a coordinate bond; or X₁ is bound to M via a coordinate bond, and X₂ is bound to M via a covalent bond,
CY₁ and CY₂ are each independently selected from a C₅-C₃₀ carbocyclic group and a C₁-C₃₀ heterocyclic group,
L₁₁ to L₁₃ are each independently selected from a substituted or unsubstituted C₅-C₃₀ carbocyclic group and a substituted or unsubstituted C₁-C₃₀ heterocyclic group,
a1 to a3 are each independently an integer from 0 to 5,
when a1 is 0, *-(L₁₁)ₐ₁-*' is a single bond; when a1 is two or greater, at least two L₁₁ groups are identical to or different from each other; when a2 is 0, *-(L₁₂)ₐ₂-*' is a single bond; when a2 is two or greater, at least two L₁₂ groups are identical to or different from each other; when a3 is 0, *-(L₁₃)ₐ₃-*' is a single bond; when a3 is two or greater, at least two L₁₃ groups are identical to or different from each other,
a sum of a1, a2, and a3 is 1 or greater,
R₁ to R₃ are each independently selected from hydrogen, deuterium, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group,-N(Q₁)(Q₂), -Si(Q₃)(Q₄)(Q₅), -B(Q₆)(Q₇), and -P(=O)(Q₈)(Q₉),
b1 to b3 are each independently an integer from 0 to 5,
R₁₁ and R₁₂ are each independently selected from
hydrogen, deuterium, a cyano group, a C₁-C₆₀ alkyl group, a C₂-C₆₀ alkenyl group, a C₂-C₆₀ alkynyl group, and a C₁-C₆₀ alkoxy group; and
a C₁-C₆₀ alkyl group, a C₂-C₆₀ alkenyl group, a C₂-C₆₀ alkynyl group, and a C₁-C₆₀ alkoxy group, each substituted with at least one selected from deuterium, a cyano group, a C₁-C₆₀ alkyl group, a C₂-C₆₀ alkenyl group, a C₂-C₆₀ alkynyl group, and a C₁-C₆₀ alkoxy group,
b11 and b12 are each independently an integer from 0 to 10,
the organometallic compound represented by Formula 2 does not comprise a fluoro group (-F), and
at least one substituent of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₇-C₆₀ arylalkyl group, substituted C₁-C₆₀ heteroaryl group, substituted C₁-C₆₀ heteroaryloxy group, substituted C₁-C₆₀ heteroarylthio group, substituted C₂-C₆₀ heteroarylalkyl group, substituted monovalent non-aromatic condensed polycyclic group, and substituted monovalent non-aromatic condensed heteropolycyclic group is selected from:
deuterium, -CD₃, -CD₂H, -CDH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -CD₃,-CD₂H, -CDH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂),-Si(Q₁₃)(Q₁₄)(Q₁₅), -B(Q₁₆)(Q₁₇), and -P(=O)(Q₁₈)(Q₁₉);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group, each substituted with at least one selected from deuterium, -CD₃, -CD₂H, -CDH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), and -P(=O)(Q₂₈)(Q₂₉); and
-N(Q₃₁)(Q₃₂), -Si(Q₃₃)(Q₃₄)(Q₃₅), -B(Q₃₆)(Q₃₇), and -P(=O)(Q₃₈)(Q₃₉),
wherein Q₁ to Q₉, Q₁₁ to Q₁₉, Q₂₁ to Q₂₉, and Q₃₁ to Q₃₉ are each independently selected from hydrogen, deuterium, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with at least one selected from a C₁-C₆₀ alkyl group and a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group.

4. The organometallic compound of claim 3, wherein X₁ is N, and X₂ is C; and/or
wherein X₁ is bound to M via a coordinate bond, and X₂ is bound to M via a covalent bond.

5. The organometallic compound of claims 3 or 4, wherein
CY₁ and CY₂ are each independently selected from i) a 5-membered ring, ii) a 6-membered ring, iii) a condensed ring in which two or more 6-membered rings are condensed, and iv) a condensed ring in which at least one 6-membered ring and at least one 5-membered ring are condensed,
the 5-membered ring is selected from a cyclopentadiene group, a furan group, a thiophene group, a pyrrole group, a silole group, an oxazole group, an isoxazole group, an oxadiazole group, an isoxadiazole group, an oxatriazole group, a thiazole group, an isothiazole group, a thiadiazole group, an isothiadiazole group, a thiatriazole group, a pyrazole group, an imidazole group, a triazole group, a tetrazole group, an azasilole group, a diazasilole group, and a triazasilole group, and
the 6-membered ring is selected from a cyclohexane group, a cyclohexene group, a benzene group, a pyridine group, a pyrimidine group, a pyrazine group, and a pyridazine group.

6. The organometallic compound of any of claims 3-5, wherein L₁₁ to L₁₃ are each independently selected from
a cyclopentadiene group, a cyclohexane group, a cyclohexene group, a benzene group, a naphthalene group, an anthracene group, a phenanthrene group, a triphenylene group, a pyrene group, a chrysene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group, each unsubstituted or substituted with at least one selected from deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group.

7. The organometallic compound of any of claims 3-6, wherein
i) a1 and a2 are each independently 1 or 2, and a3 is 0;
ii) a1 and a2 are each 0, and a3 is 1, 2, or 3; or
iii) a1 to a3 are each 1.

8. The organometallic compound of any of claims 3-7, wherein R₁ to R₃, R₁₁, and R₁₂ are each independently selected from
hydrogen, deuterium, a cyano group, a C₁-C₁₀ alkyl group, and a C₁-C₁₀ alkoxy group; and
a C₁-C₁₀ alkyl group and a C₁-C₁₀ alkoxy group, each substituted with at least one selected from deuterium, a cyano group, a C₁-C₁₀ alkyl group, and a C₁-C₁₀ alkoxy group.

9. The organometallic compound of any of claims 3-8, wherein R₁ to R₃, R₁₁, and R₁₂ are each independently selected from hydrogen, deuterium, a cyano group, -CH₃, -CD₃, -CD₂H, -CDH₂, -CH₂CD₂H, -CH₂CDH₂, -CHDCH₃, -CHDCD₂H,-CHDCDH₂, -CHDCD₃, -CD₂CD₃, -CD₂CH₃, -CD₂CD₂H, -CD₂CDH₂, groups represented by Formulae 9-1 to 9-24, a methoxy group, an ethoxy group, a propoxy group, a butoxy group, and a pentoxy group: 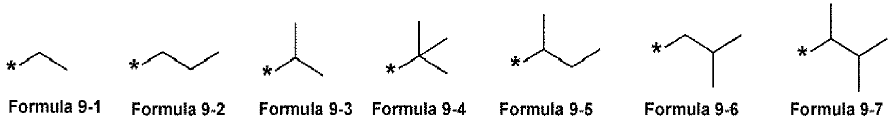 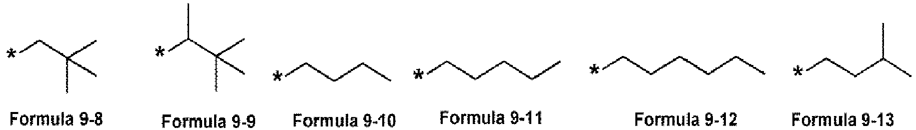 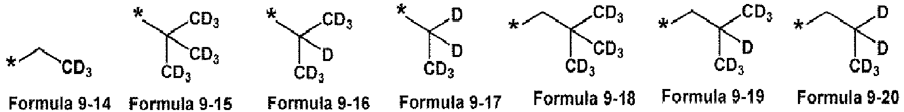 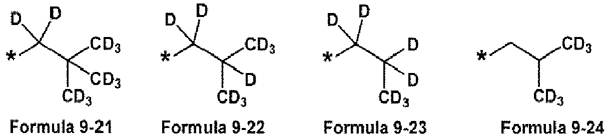 wherein, in Formulae 9-1 to 9-24, * indicates a binding site to an adjacent atom.

10. The organometallic compound of any of claims 3-9, wherein, in Formula 2, *-(L₁₁)ₐ₁-(R₁)_{b1}, *-(L₁₂)ₐ₂-(R₂)_{b2}, and *-(L₁₃)ₐ₃-(R₃)_{b3} are each independently selected from:
hydrogen, deuterium, a cyano group, a C₁-C₁₀ alkyl group, and a C₁-C₁₀ alkoxy group;
a C₁-C₁₀ alkyl group and a C₁-C₁₀ alkoxy group, each substituted with at least one selected from deuterium, a cyano group, a C₁-C₁₀ alkyl group, and a C₁-C₁₀ alkoxy group; and
groups represented by Formulae 10-1 to 10-154, wherein
at least one selected from *-(L₁₁)ₐ₁-(R₁)_{b1}, *-(L₁₂)ₐ₂-(R₂)_{b2}, and *-(L₁₃)ₐ₃-(R₃)_{b3} is independently selected from groups represented by Formulae 10-1 to 10-4, 10-9, 10-10 and 10-13 to 10-154: 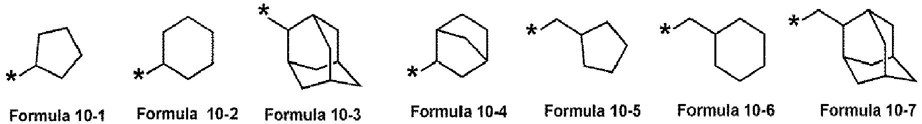 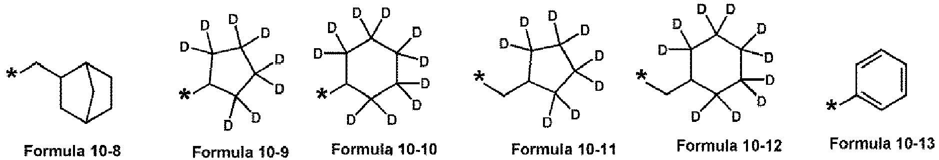 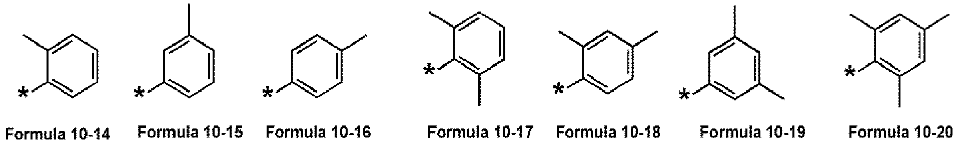 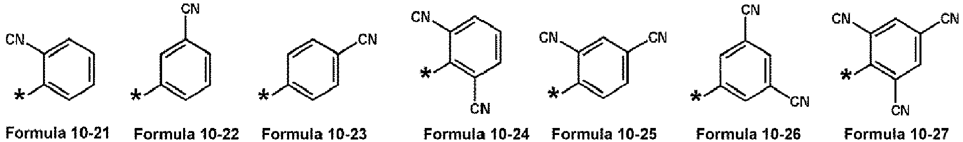 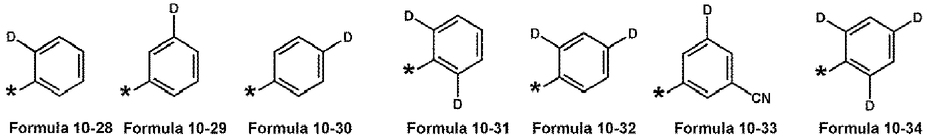 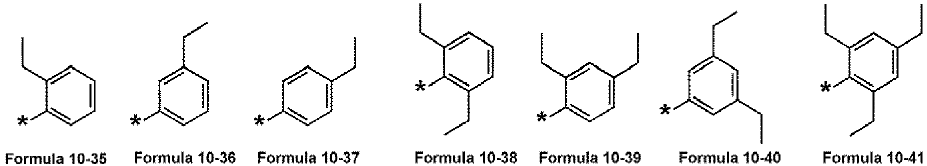 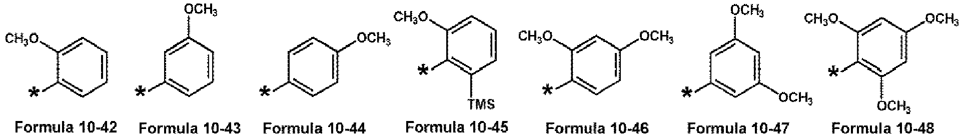 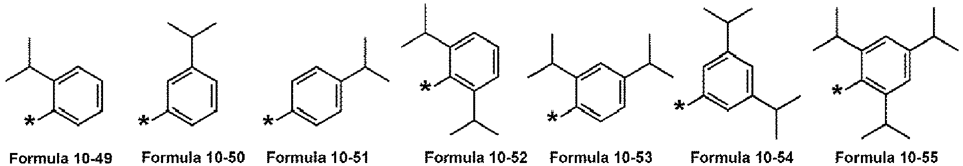 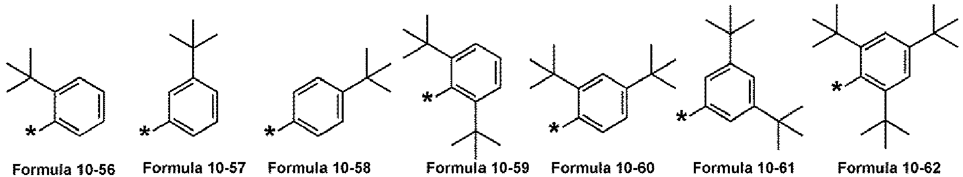 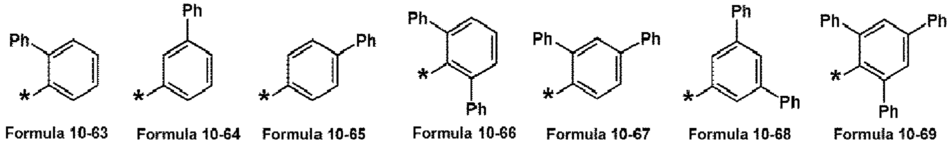 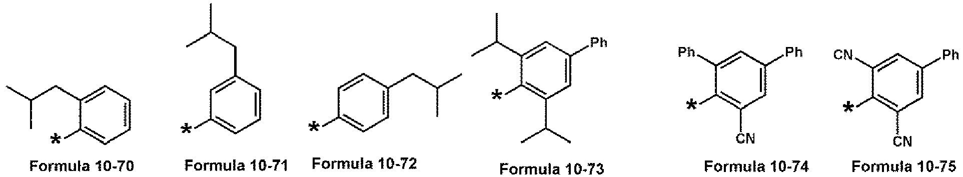 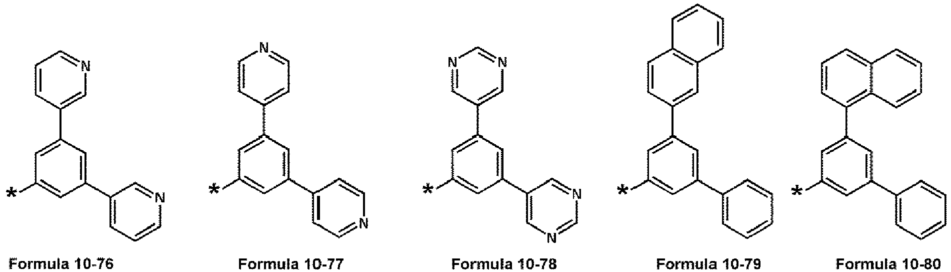 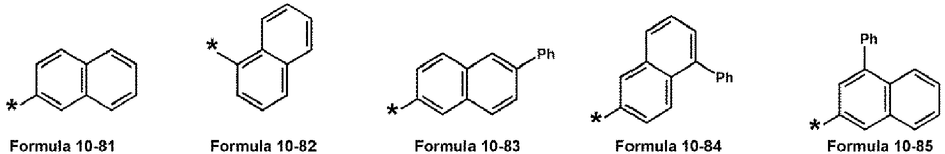 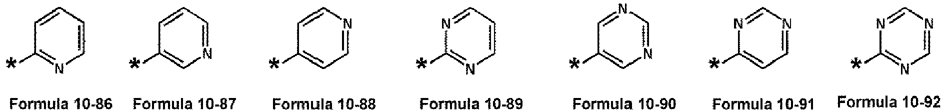 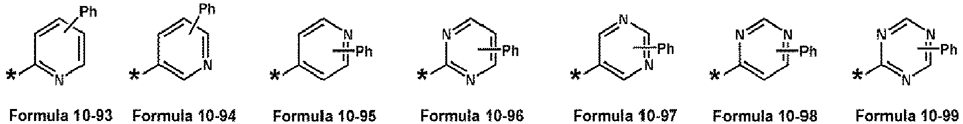 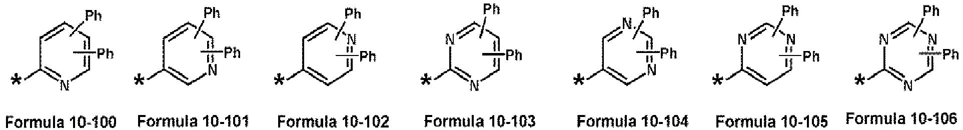 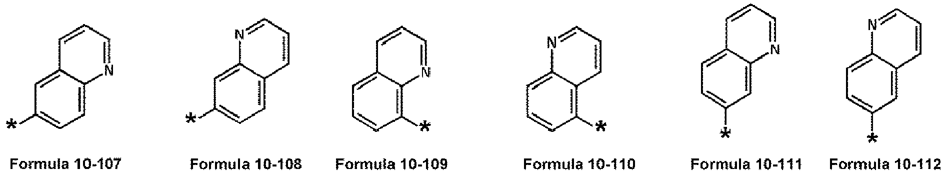 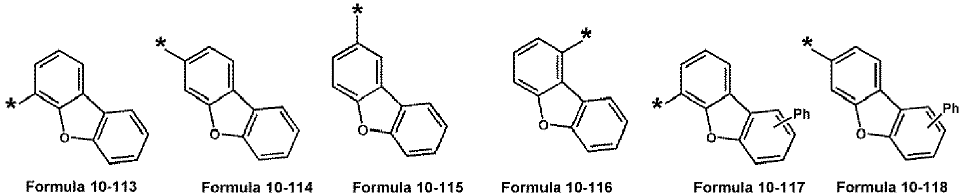 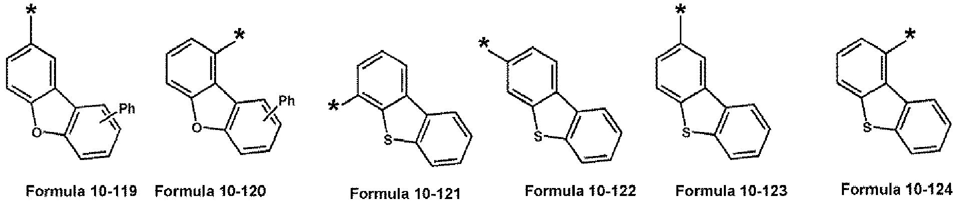 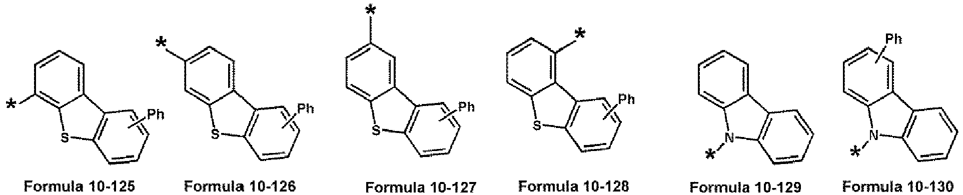 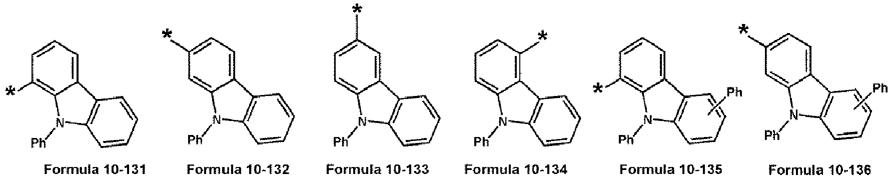 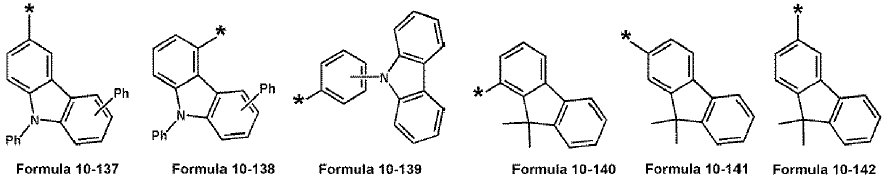 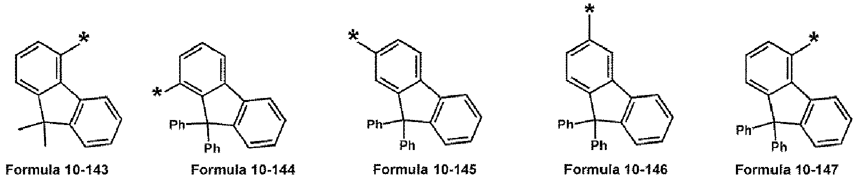 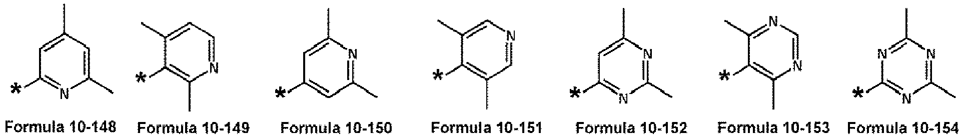 wherein, in Formulae 10-1 to 10-154, Ph represents a phenyl group, and * indicates a binding site to an adjacent atom.

11. The organometallic compound of any of claims 3-10, represented by one of Formulae 2A to 2C: 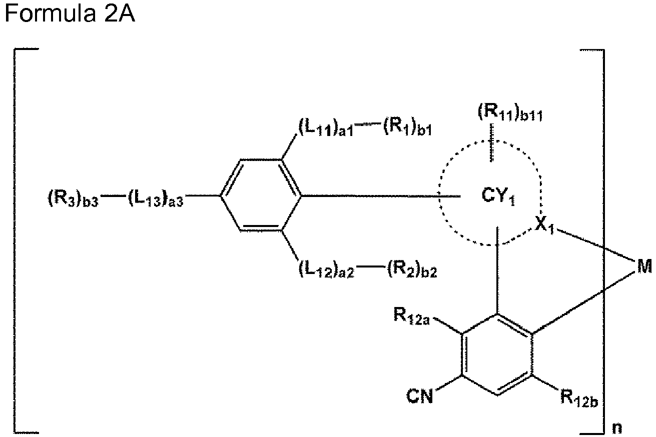 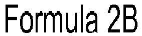 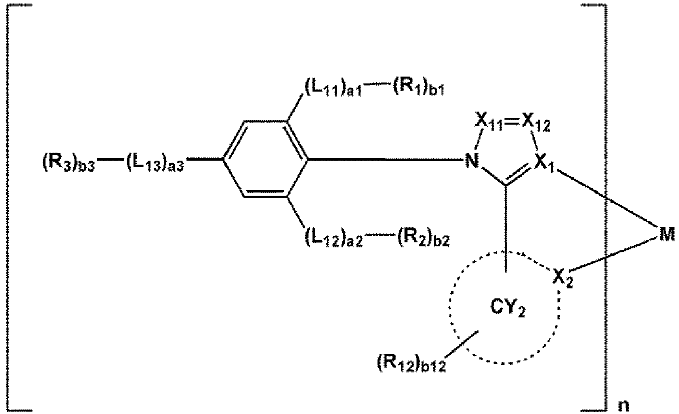 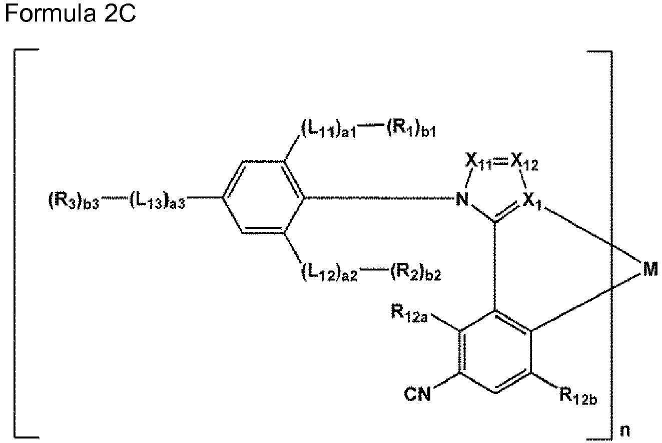 wherein, in Formulae 2A to 2C,
M, n, X₁, X₂, CY₁, CY₂, L₁₁ to L₁₃, a1 to a3, R₁ to R₃, b1 to b3, R₁₁, R₁₂, b11, and b12 are the same as those defined in claim 3,
X₁₁ is N or C(R₁₁ₐ), X₁₂ is N or C(R_{11b}),
R₁₁ₐ and R_{11b} are each the same as R₁₁ as defined in claim 3, and
R₁₂ₐ and R_{12b} are each the same as R₁₂ as defined in claim 3.

12. The organometallic compound of any of claims 1-11, selected from Compounds 1 to 9:

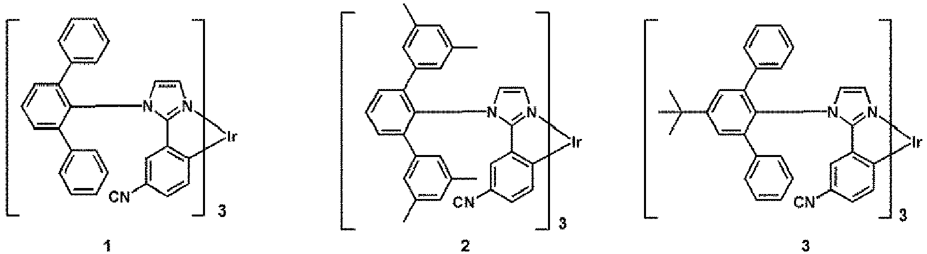

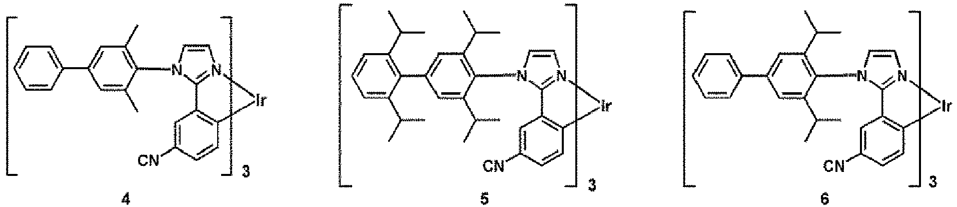

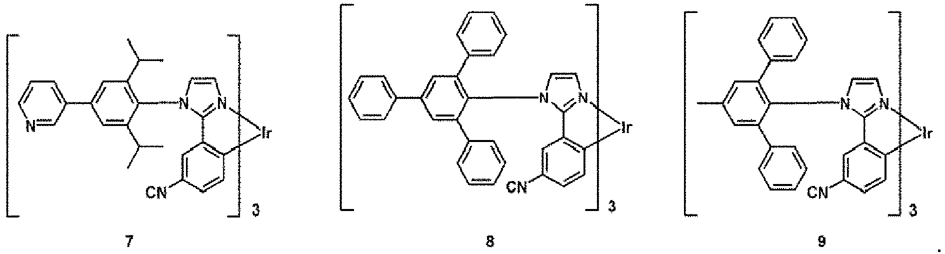

13. An organic light-emitting device comprising:
a first electrode;
a second electrode; and
an organic layer disposed between the first electrode and the second electrode,
wherein the organic layer comprises an emission layer and at least one organometallic compound of any of claims 1-12;
preferably wherein the emission layer comprises the organometallic compound.

14. The organic light-emitting device of claim 13, wherein a horizontal orientation ratio of a transition dipole moment of the organometallic compound with respect to a plane of the emission layer is in a range of 85 percent to 100 percent; and/or
wherein the emission layer further comprises a host.

15. The organic light-emitting device of claim 14, wherein the host comprises at least one of compounds comprising at least one selected from a carbazole group, a fluorene group, a spirobifluorene group, a dibenzofuran group, a dibenzothiophene group, a dibenzosilole group, an indenocarbazole group, an indolocarbazole group, a benzofurocarbazole group, a benzothienocarbazole group, an acridine group, a dihydroacridine group, a triindolobenzene group, an azadibenzofuran group, an azadibenzothiophene group, an azacarbazole group, an azafluorene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a phenazine group, a cinnoline group, a cyano group, a phosphine oxide group, and a sulfoxide group;
preferably wherein the host comprises a hole transport host and an electron transport host.
